# EUROPEAN PATENT SPECIFICATION

(11) **EP 4 470 351 B1**
(45) Date of publication and mention of the grant of the patent: **27.05.2026**
(21) Application number: 23712784.0
(22) Date of filing: 02.03.2023
(51) Int. Cl.: H10B 41/27, H10B 43/27

(54) **THREE-DIMENSIONAL MEMORY DEVICES**
DREIDIMENSIONALE SPEICHERVORRICHTUNGEN
DISPOSITIFS DE MÉMOIRE TRIDIMENSIONNELS

(30) Priority: 16.11.2022 CN 202211461085
(43) Date of publication of application: 04.12.2024
(73) Proprietor: Yangtze Memory Technologies Co., Ltd., Wuhan, Hubei 430000 (CN)
(72) Inventor: ZHANG, Mingkang, Wuhan, Hubei 430000 (CN); XIAO, Liang, Wuhan, Hubei 430000 (CN); ZHAO, Yi, Wuhan, Hubei 430000 (CN); WU, Shu, Wuhan, Hubei 430000 (CN); ZHOU, Wenbin, Wuhan, Hubei 430000 (CN)
(74) Representative: Gramm, Lins & Partner Patent- und Rechtsanwälte PartGmbB
(86) International application number: PCT/CN2023/079247
(87) International publication number: WO 2024/103569

(56) References cited:
- US-A1- 2021 375 912
- US-A1- 2021 391 315

## Description

### BACKGROUND

The present disclosure relates to three-dimensional (3D) memory devices and fabrication methods thereof.

Planar memory cells are scaled to smaller sizes by improving process technology, circuit design, programming algorithm, and fabrication process. However, as feature sizes of the memory cells approach a lower limit, planar process and fabrication techniques become challenging and costly. As a result, memory density for planar memory cells approaches an upper limit. A 3D memory architecture can address the density limitation in planar memory cells. The 3D memory architecture includes a memory array and peripheral circuits for controlling signals to and from the memory array.
US 2021/391315 A1 discloses a three-dimensional memory device.

### SUMMARY

The present disclosure describes embodiments of 3D memory devices and methods for forming the 3D memory devices.

One aspect relates to a method for forming a 3D memory device according to claim 1.

Another aspect relates to a 3D memory device according to claim 12.

One embodiment could relate to a system including a controller and a 3D memory device coupled to the controller. The 3D memory device includes: a multi-layer stacked structure, wherein the multi-layer stacked structure comprises a plurality of alternately stacked conductive layers and dielectric layers; a semiconductor layer over the multi-layer stacked structure; and a plurality of channel structures penetrating the multi-layer stacked structure and the semiconductor layer, wherein a first end of each channel structure is located within the semiconductor layer, and wherein the first ends of the channel structures are substantially aligned with one another.

Other aspects, features and various advantages present in some implementations will be readily apparent from the following detailed description, the accompanying drawings, and the claims.

### BRIEF DESCRIPTION OF THE DRAWINGS

The accompanying drawings, which are incorporated herein and form a part of the specification, illustrate embodiments of the present disclosure and, together with the description, further serve to explain the principles of the present disclosure and to enable a person skilled in the pertinent art to make and use the present disclosure.
FIG. 1A illustrates a schematic view of an example of 3D memory device 110, according to some embodiments.
FIG. 1B illustrates a schematic view of another example of 3D memory device 120, according to some embodiments.
FIG. 2 illustrates a side view of a cross-section of an example of 3D memory device, according to some examples not forming part of the invention.
FIG. 3 illustrates a top view of a cross-section of an example of channel structure, according to some embodiments of the present disclosure.
FIG. 4 illustrates a side view of a cross-section of another example of 3D memory device, according to some embodiments of the present disclosure.
FIGS. 5-17 illustrate a fabrication process for forming an example of 3D memory device, according to some examples not forming part of the invention.
FIGS. 18-24 illustrate another fabrication process for forming an example of 3D memory device, according to some embodiments of the present disclosure.
FIGS. 25-37 illustrate yet another fabrication process for forming example of 3D memory devices, according to some embodiments of the present disclosure.
FIG. 38 illustrates a flowchart of a method for forming an example of 3D memory device, according to some embodiments of the present disclosure.
FIG. 39 illustrates a block diagram of an example of system having a memory device, according to some embodiments of the present disclosure.
FIG. 40 illustrates a diagram of an example of memory card having a memory device, according to some embodiments of the present disclosure.
FIG. 41 illustrates a diagram of an example of solid-state drive (SSD) having a memory device, according to some embodiments of the present disclosure.

### DETAILED DESCRIPTION

Although specific configurations and arrangements are discussed, it should be understood that this is done for illustrative purposes only. A person skilled in the pertinent art will recognize that other configurations and arrangements can be used without departing from the spirit and scope of the present disclosure. It will be apparent to a person skilled in the pertinent art that the present disclosure can also be employed in a variety of other applications.

It is noted that references in the specification to "one embodiment," "an embodiment," "an example embodiment," "some embodiments," etc., indicate that the embodiment described may include a particular feature, structure, or characteristic, but other embodiments may not necessarily include the particular feature, structure, or characteristic. Moreover, such phrases do not necessarily refer to the same embodiment. Further, when a particular feature, structure, or characteristic is described in connection with an embodiment, it would be within the knowledge of a person skilled in the pertinent art to effect such feature, structure or characteristic in connection with other embodiments whether or not explicitly described.

In general, terminology may be understood at least in part from usage in context. For example, the term "one or more" as used herein, depending at least in part upon context, may be used to describe any feature, structure, or characteristic in a singular sense or may be used to describe combinations of features, structures or characteristics in a plural sense. Similarly, terms, such as "a," "an," or "the," again, may be understood to convey a singular usage or to convey a plural usage, depending at least in part upon context. In addition, the term "based on" may be understood as not necessarily intended to convey an exclusive set of factors and may, instead, allow for existence of additional factors not necessarily expressly described, again, depending at least in part on context.

It should be readily understood that the meaning of "on," "above," and "over" in the present disclosure should be interpreted in the broadest manner such that "on" not only means "directly on" something but also includes the meaning of "on" something with an intermediate feature or a layer therebetween, and that "above" or "over" not only conveys the meaning of "above" or "over" something but can also include the meaning it is "above" or "over" something with no intermediate feature or layer therebetween (i.e., directly on something).

Further, spatially relative terms, such as "beneath," "below," "lower," "above," "upper," and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "substrate" refers to a material onto which subsequent material layers are added. The substrate itself can be patterned. Materials added on top of the substrate can be patterned or can remain unpatterned. Furthermore, the substrate can include a wide array of semiconductor materials, such as silicon, germanium, gallium arsenide, indium phosphide, etc. Alternatively, the substrate can be made from an electrically non-conductive material, such as a glass, a plastic, or a sapphire wafer.

As used herein, the term "layer" refers to a material portion including a region with a thickness. A layer can extend over the entirety of an underlying or overlying structure or may have an extent less than the extent of an underlying or overlying structure. Further, a layer can be a region of a homogeneous or inhomogeneous continuous structure that has a thickness less than the thickness of the continuous structure. For example, a layer can be located between any pair of horizontal planes between, or at, a top surface and a bottom surface of the continuous structure. A layer can extend horizontally, vertically, and/or along a tapered surface. A substrate can be a layer, can include one or more layers therein, and/or can have one or more layers thereupon, thereabove, and/or therebelow. A layer can include multiple layers. For example, an interconnect layer can include one or more conductor and contact layers (in which interconnect lines and/or vertical interconnect access (via) contacts are formed) and one or more dielectric layers.

As used herein, the term "about" indicates the value of a given quantity that can vary based on a particular technology node associated with the subject semiconductor device. Based on the particular technology node, the term "about" can indicate a value of a given quantity that varies within the value.

As used herein, the term "3D memory device" refers to a semiconductor device with vertically oriented strings of memory cell transistors (referred to herein as "memory strings," such as NAND memory strings) on a laterally oriented substrate so that the memory strings extend in the vertical direction with respect to the substrate. As used herein, the term "vertical/vertically" means nominally perpendicular to the lateral surface of the substrate.

As the feature size of the semiconductor manufacturing process becomes smaller, the storage density of the storage device becomes higher, and the application of the 3D memory is born. To increase the storage capacity of the 3D memory, the number of stacked layers and the number of initial channel structures of the stacked structure of the 3D memory are continuously increasing. However, as the number of stacked layers increases, the depth of the channel holes also increases, making it difficult to ensure that the extension depths of each channel hole are the same during the process of etching the channel holes, which in turn leads to increased complexity of the fabrication process and reduced product yield.

In the present disclosure, the portion of each channel structure penetrating into the semiconductor layer can be processed such that an upper end of each channel structure can be aligned horizontally, and a top surface of the semiconductor layer formed over the channel structure is planarized. Therefore, some implementations of the present disclosure can not only make the dielectric layer formed over the semiconductor layer thinner, but can also reduce the aspect ratio of the lead-out contacts that are subsequently formed, penetrating the semiconductor layer, which can expand the range of materials for the lead-out contact, thereby eliminating an additional step of forming connection for the lead-out contact. In some implementations, such features can also lift the restriction on the formation position of the lead-out contacts due to the different depths of gate slit lines, and reduce the difficulty of a subsequent chemical mechanical polishing (CMP) process. As a result, the complexity and cost of the fabrication process can be reduced, and the product yield can be increased in some cases.

In the present disclosure, the 3D memory device can further include a sealing structure disposed at an upper end of each channel structure. The sealing structure can be formed in a channel structure to seal a top portion of the channel structure to prevent other material used in subsequent processes from entering into the channel structure, which may adversely affect an electrical property of the channel structure. As a result, the performance of the device can be improved in some cases.

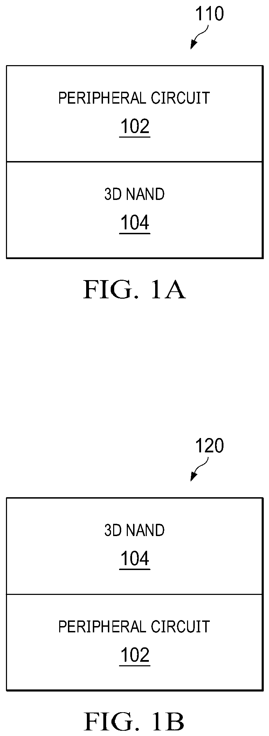

FIG. 1A illustrates a schematic view of a cross-section of an example of 3D memory device 110, according to some embodiments. 3D memory device 110 represents an example of a non-monolithic 3D memory device. The term "non-monolithic" means that the components of 3D memory device 110 (e.g., peripheral circuit and 3D NAND memory) can be formed separately on different substrates and then joined to form a 3D memory device.

3D memory device 110 can include a first semiconductor structure 102 including peripheral circuits. The peripheral circuits can be implemented, for example, with advanced logic processes (e.g., technology nodes of 90 nm, 80 nm, 65 nm, 55 nm, 45 nm, 40 nm, 32 nm, 28 nm, 22 nm, 20 nm, 16 nm, 14 nm, 10 nm, 7 nm, 5 nm, 3 nm, etc.) to achieve high speed. In some embodiments, the peripheral circuits in first semiconductor structure 102 are implemented using complementary metal-oxide-semiconductor (CMOS) technology. In some embodiments, peripheral circuits in first semiconductor structure 102 can include a controller configured to control the 3D NAND memory device.

In some embodiments, the peripheral circuits include any suitable digital, analog, and/or mixed-signal peripheral circuits used for facilitating the operation of 3D memory device 110. For example, the peripheral circuits can include one or more of a page buffer, a decoder (e.g., a row decoder and a column decoder), a sense amplifier, a driver, a charge pump, a current or voltage reference, or any active or passive components of the circuits (e.g., transistors, diodes, resistors, or capacitors).

3D memory device 110 can also include a second semiconductor structure 104 including an array of 3D NAND memory strings. Second semiconductor structure 104 can be, for example, a NAND flash memory in which memory cells are provided in the form of an array of NAND memory strings. In some embodiments, depending on the NAND technology (e.g., the number of levels/tiers in the memory stack), a 3D NAND memory string typically consists of 32 to 256 NAND memory cells. 3D NAND memory strings can be organized into pages which are then organized into blocks in which each 3D NAND memory string is connected to a separate line called a bit line (BL). All cells with the same position in the 3D NAND memory string can be connected through the control gates by a word line (WL). In some embodiments, a plane contains a certain number of blocks that are connected through the same bit line. Second semiconductor structure 104 can include one or more planes, and the peripheral circuits that are needed to perform all the read/write/erase operations can be included in first semiconductor structure 102.

3D memory device 110 can further include a bonding interface (not shown) between first and second semiconductor structures 102 and 104. First and second semiconductor structures 102 and 104 can be fabricated separately (and in parallel in some embodiments) such that the thermal budget of fabricating one of first and second semiconductor structures 102 and 104 does not limit the processes of fabricating another one of first and second semiconductor structures 102 and 104. Moreover, a large number of interconnects (e.g., bonding contacts via hybrid bonding) can be formed through the bonding interface to make direct, short, electrical connections between first semiconductor structure 102 and second semiconductor structure 104, as opposed to the long-distance chip-to-chip data bus on the circuit board, thereby eliminating chip interface delay and achieving high-speed I/0 throughput with reduced power consumption. Data transfer between the array of 3D NAND memory strings in second semiconductor structure 104 and the peripheral circuits in first semiconductor structure 102 can be performed through the interconnects (e.g., bonding contacts via hybrid bonding) across the bonding interface. Furthermore, by vertically integrating first and second semiconductor structures 102 and 104, the chip size can be reduced, and the memory cell density can be increased.

The relative positions of stacked first and second semiconductor structures 102 and 104 are not limited. FIG. 1B illustrates a schematic view of a cross-section of another example of 3D memory device 120, according to some embodiments. Different from 3D memory device 110 in FIG. 1A in which first semiconductor structure 102 is above second semiconductor structure 104, in 3D memory device 120 in FIG. 1B, second semiconductor structure 104 is above first semiconductor structure 102. Nevertheless, a bonding interface (not shown) can also be formed vertically between first and second semiconductor structures 102 and 104 in 3D memory device 120, and first and second semiconductor structures 102 and 104 are joined vertically through bonding (e.g., hybrid bonding) according to some embodiments. Data transfer between the array of 3D NAND memory strings in second semiconductor structure 104 and the peripheral circuits in first semiconductor structure 102 can be performed through interconnects across the bonding interface.

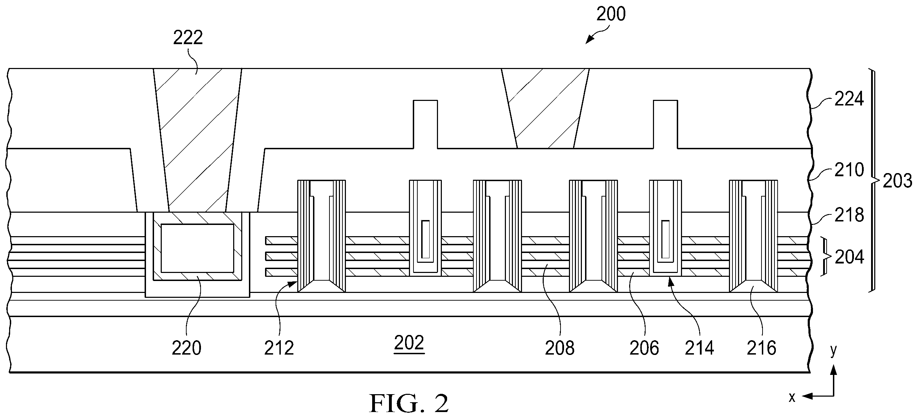

FIG. 2 illustrates a side view of a cross-section of an example of 3D memory device 200, not forming part of the claimed invention. In some embodiments, 3D memory device 200 is a bonded chip including first structure 202 and second structure 203 stacked over first structure 202. First and second structures 202 and 203 are jointed at a bonding interface (not shown), according to some embodiments. As used herein, whether one component (e.g., a layer or a device) is "on," "above," "over" or "below" another component (e.g., a layer or a device) of a device (e.g., 3D memory device 200) is determined relative to the structure or layer (e.g., first structure 202) in the y-direction (i.e., the vertical direction) when the structure or layer (e.g., first structure 202) is positioned in the lowest plane of the device in the y-direction. The same notion for describing spatial relationships is applied throughout the present disclosure.

In some embodiments, first structure 202 can include peripheral circuits, and the peripheral circuits can be configured to control signals to and from the memory array of 3D memory device 200. The peripheral circuits can be any suitable digital, analog, and/or mixed-signal control and sensing circuits used for facilitating the operation of 3D memory device 200 including, but not limited to, a page buffer, a decoder (e.g., a row decoder and a column decoder), a sense amplifier, a driver (e.g., a word line driver), a charge pump, a current or voltage reference, or any active or passive components of the circuit (e.g., transistors, diodes, resistors, or capacitors). The peripheral circuits can include transistors formed "on" a substrate (not shown), in which the entirety or part of the transistors are formed in the substrate and/or directly on the substrate. Isolation regions (e.g., shallow trench isolations (STIs)) and doped regions (e.g., source regions and drain regions of the transistors) can be formed in the substrate as well. The transistors are high-speed with advanced logic processes, according to some embodiments. In some embodiments, the peripheral circuit(s) may further include other circuits compatible with the advanced logic processes including logic circuits, such as processors and programmable logic devices (PLDs), or memory circuits, such as static random-access memory (SRAM) and dynamic RAM (DRAM).

In some embodiments, first structure 202 further includes an interconnect layer (not shown) to transfer electrical signals to and from the peripheral circuits. The interconnect layer can include a plurality of interconnects (also referred to herein as "contacts"), including lateral interconnect lines and vertical interconnect access (VIA) contacts. As used herein, the term "interconnects" can broadly include any suitable types of interconnects, such as middle-end-of-line (MEOL) interconnects and back-end-of-line (BEOL) interconnects. The interconnect layer can further include one or more interlayer dielectric (ILD) layers (also known as "intermetal dielectric (IMD) layers") in which the interconnect lines and VIA contacts can form. That is, the interconnect layer can include interconnect lines and VIA contacts in multiple ILD layers. The interconnect lines and VIA contacts in the interconnect layer can include conductive materials including, but not limited to, tungsten (W), cobalt (Co), copper (Cu), aluminum (Al), silicides, or any combination thereof. The ILD layers in the interconnect layer can include dielectric materials including, but not limited to, silicon oxide, silicon nitride, silicon oxynitride, low dielectric constant (low-k) dielectrics, or any combination thereof.

First structure 202 can further include a bonding layer (not shown) above the interconnect layer and peripheral circuits. The bonding layer can include bonding contacts and dielectrics electrically isolating the bonding contacts. Bonding contacts can include conductive materials including, but not limited to, W, Co, Cu, Al, silicides, or any combination thereof. The remaining area of bonding layer can be formed with dielectrics including, but not limited to, silicon oxide, silicon nitride, silicon oxynitride, low-k dielectrics, or any combination thereof. Bonding contacts and surrounding dielectrics in the bonding layer can be used for hybrid bonding.

Second structure 203 can also include a bonding layer that includes a plurality of bonding contacts and dielectrics electrically isolating bonding contacts. The bonding contacts of second structure 203 can include conductive materials including, but not limited to, W, Co, Cu, Al, silicides, or any combination thereof. The remaining area of the bonding layer of the second structure 203 can be formed with dielectrics including, but not limited to, silicon oxide, silicon nitride, silicon oxynitride, low-k dielectrics, or any combination thereof. The bonding contacts and surrounding dielectrics in the bonding layer of second structure 203 can be used for hybrid bonding.

Second structure 203 can be bonded on top of first structure 202 in a face-to-face manner. In some embodiments, first and second structures 202 and 203 can be bonded by hybrid bonding (also known as "metal/dielectric hybrid bonding"), which is a direct bonding technology (e.g., forming bonding between surfaces without using intermediate layers, such as solder or adhesives) and can obtain metal-metal bonding and dielectric-dielectric bonding simultaneously.

In some embodiments, second structure 203 further includes an interconnect layer (not shown) to transfer electrical signals. The interconnect layer can include a plurality of interconnects, such as MEOL interconnects and BEOL interconnects. The interconnect layer can further include one or more ILD layers in which the interconnect lines and VIA contacts can form. The interconnect lines and VIA contacts in the interconnect layer can include conductive materials including, but not limited to W, Co, Cu, Al, silicides, or any combination thereof. The ILD layers in the interconnect layer can include dielectric materials including, but not limited to, silicon oxide, silicon nitride, silicon oxynitride, low-k dielectrics, or any combination thereof.

In some embodiments, 3D memory device 200 is a NAND flash memory device in which memory cells are provided in the form of an array of NAND memory strings. As shown in FIG. 2, second structure 203 of 3D memory device 200 can include an array of channel structures 212 functioning as the array of NAND memory strings. As shown in FIG. 2, each channel structure 212 penetrates through a multi-layer stacked structure 204 including alternately stacked conductive layers 206 and dielectric layers 208. The number of the pairs of conductive layers 206 and dielectric layers 208 determines the number of memory cells in 3D memory device 200. As shown, conductive layers 206 and dielectric layers 208 can alternate in the vertical direction. In other words, except the ones at the top or bottom of multi-layer stacked structure 204, each conductive layer 206 can be sandwiched between two dielectric layers 208 on both sides, and each dielectric layer 208 can be sandwiched between two conductive layers 206 on both sides. Conductive layers 206 can include conductive materials, for example, including, but not limited to, W, Co, Cu, Al, polysilicon, doped silicon, silicides, or any combination thereof. Each conductive layer 206 can include, for example, a gate electrode (gate line) surrounded by an adhesive layer and a gate dielectric layer. The gate electrode of conductive layer 206 can extend laterally as a word line, ending at one or more staircase structures of multi-layer stacked structure 204. Dielectric layers 208 can include dielectric materials, for example, including, but not limited to, silicon oxide, silicon nitride, silicon oxynitride, or any combination thereof.

In some embodiments, second structure 203 includes dielectric layer 218 over multi-layer stacked structure 204. Dielectric layer 218 can include dielectric materials, for example, including, but not limited to, silicon oxide, silicon nitride, silicon oxynitride, or any combination thereof. In some embodiments, dielectric layer 218 and dielectric layers 208 are composed of the same material. In some embodiments, dielectric layer 218 can be a part of multi-layer stacked structure 204.

As shown in FIG. 2, second structure 203 can also include semiconductor layer 210 above multi-layer stacked structure 204, such that dielectric layer 218 is disposed between multi-layer stacked structure 204 and semiconductor layer 210. In some embodiments, semiconductor layer 210 can be a crystalline silicon (c-Si) layer formed using one or more thin film deposition processes including, but not limited to, CVD, PVD, or any combination thereof. In some embodiments, semiconductor layer 210 can be an undoped semiconductor layer. In some embodiments, semiconductor layer 210 can be a doped semiconductor layer (e.g., N-type doped). Semiconductor layer 210 can be doped with any suitable dopants, such as phosphorus (P), arsenic (Ar), or antimony (Sb), which contribute free electrons and increase the conductivity of the intrinsic semiconductor. For example, semiconductor layer 210 may be a semiconductor layer doped with N-type dopant(s), such as P, Ar, or Sb.

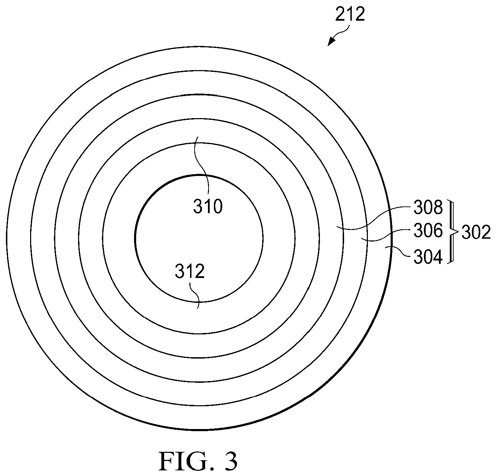

In some embodiments, referring to FIG. 3, each channel structure 212 includes a channel hole partially filled with dielectric filler layer 312, semiconductor channel layer 310, and channel film 302. In some embodiments, dielectric filler layer 312 includes dielectric materials, such as silicon oxide. Semiconductor channel layer 310 can include, for example, silicon, such as amorphous silicon, polysilicon, or single crystalline silicon. Channel film 302 can be a composite layer including tunneling layer 308, storage layer 306 (also known as a "charge trap layer"), and blocking layer 304. In some embodiments, channel structure 212 can have a cylinder shape (e.g., a pillar shape). As shown, dielectric filler layer 312, semiconductor channel layer 310, tunneling layer 308, storage layer 306, and blocking layer 304 are arranged radially from the center of channel structure 212 toward the outer surface of the pillar in this order, according to some embodiments. In some embodiments, tunneling layer 308 can include silicon oxide, silicon oxynitride, or any combination thereof. Storage layer 306 can include, for example, silicon nitride, silicon oxynitride, silicon, or any combination thereof. Blocking layer 304 can include, for example, silicon oxide, silicon oxynitride, high-k dielectrics, or any combination thereof. In one example, channel film 302 includes a composite layer of silicon oxide/silicon oxynitride/ silicon oxide (ONO).

Referring back to FIG. 2, in some embodiments, channel structure 212 further includes a channel plug 216 in the bottom portion (e.g., at the lower end) of channel structure 212. As used herein, the "upper end" of a component (e.g., channel structure 212) is the end farther away from first structure 202 in the y-direction, and the "lower end" of the component (e.g., channel structure 212) is the end closer to first structure 202 in the y-direction when first structure 202 is positioned in the lowest plane of 3D memory device 200. Channel plug 216 can include, for example, semiconductor materials (e.g., polysilicon). In some embodiments, channel plug 216 functions as the drain of the NAND memory string.

As further shown in FIG. 2, each channel structure 212 can extend vertically through interleaved conductive layers 206 and dielectric layers 208 of multi-layer stacked structure 204 into semiconductor layer 210. In some embodiments, the upper end of each channel structure 212 is below the top surface of semiconductor layer 210. That is, channel structure 212 does not extend beyond the top surface of semiconductor layer 210, according to some embodiments. In some embodiments, a top surface of dielectric filler layer 312 of channel structure 212 is below a top surface of the other portions of channel structure 212, e.g., semiconductor channel layer 310 and channel film 302. Here, the top surfaces of dielectric filler layer 312 and the other portions of channel structure 212 are surfaces that face away from multi-layer stacked structure 204. Channel film 302 and semiconductor channel layer 310 can extend beyond the bottom surface of semiconductor layer 210, such that semiconductor layer 210 may surround a top portion of channel film 302 that penetrates into semiconductor layer 210. In some embodiments, the top surfaces of channel structures 212 are substantially aligned with one other along the x direction. In one example, the term "substantially" can indicate a value of a given quantity that varies within a predetermined range of value, e.g., ±5%, or ±10% of the value. In some embodiments, a position variance of the top surfaces of channel structures 212 can be within 30 nanometers. In one example, a position variance of the top surfaces of channel structures 212 can be within 20 nanometers.

As shown in FIG. 2, second structure 203 can further include filled slit structures 214, each penetrating vertically through interleaved conductive layers 206 and dielectric layers 208 of multi-layer stacked structure 204. In some embodiments, filled slit structures 214 can provide electrical connections to the source of the memory array of the second structure 203. In some embodiments, filled slit structures 214 include wall-shaped polysilicon and/or metal fillings. Filled slit structures 214 extend vertically into semiconductor layer 210, according to some embodiments. Each filled slit structure 214 can also extend laterally to separate channel structures 212 into different blocks. In some embodiments, each filled slit structure 214 includes an opening (e.g., a slit) filled with one or more dielectric materials, for example, including, but not limited to, silicon oxide, silicon nitride, silicon oxynitride, or any combination thereof. In one example, each filled slit structure 214 is filled with silicon oxide.

3D memory device 200 can include lead-out contacts 222, as shown in FIG. 2. Lead-out contacts 222 and multi-layer stacked structure 204 can be disposed at opposite sides of semiconductor layer 210 and thus, lead-out contact 222 can be viewed as a "backside" contact. Lead-out contacts 222 can include any suitable types of contacts. In some embodiments, lead-out contacts 222 include a VIA contact. In some embodiments, lead-out contacts 222 include a wall-shaped contact extending laterally. In some embodiments, lead-out contact 222 is electrically connected to word line contact 220. In some embodiments, word line contact 220 is below and in contact with lead-out contact 222. Each of word line contacts 220 and lead-out contacts 222 can include one or more conductive layers, such as a metal layer (e.g., W, Co, Cu, or Al) or a silicide layer surrounded by an adhesive layer (e.g., TiN).

Second structure 203 can further include dielectric layer 224 disposed over semiconductor layer 210. Lead-out contacts 222 can be electrically separated by dielectric layer 224. In some embodiments, lead-out contacts 222 penetrate and extend vertically through dielectric layer 224. In some embodiments, the lower end of a source contact 222 does not extend downwardly beyond the bottom surface of dielectric layer 224. In some embodiments, a portion of dielectric layer 224 penetrates through semiconductor layer 210, and a lead-out contact 222 can penetrate through the portion of dielectric layer 224 that penetrates through semiconductor layer 210 to be connected with word line contact 220. Dielectric layer 224 can include, for example, silicon oxide, silicon nitride, silicon oxynitride, low-k dielectrics, or any combination thereof.

In the present disclosure, the portion of each channel structure 212 penetrating the semiconductor layer 210 can be processed such that an upper end of each channel structure 212 is aligned horizontally, and a top surface of the semiconductor layer 210 formed over the channel structure 212 is planarized. Therefore, in some cases, the processing can not only make the dielectric layer 224 formed over the semiconductor layer 210 thinner, but can also reduce the aspect ratio of the lead-out contacts 222 that are subsequently formed, penetrating dielectric layer 224 and semiconductor layer 210, which can increase the range of materials that can be used for lead-out contacts 222, thereby eliminating an additional step of forming connection for the lead-out contacts 222. In some cases, such features can also lift the restriction on the formation position of the lead-out contacts 222 due to the different depths of gate slit lines 214, and reduce the difficulty of a subsequent CMP process. As a result, the complexity and cost of the fabrication process can be reduced, and the product yield can be increased in some cases.

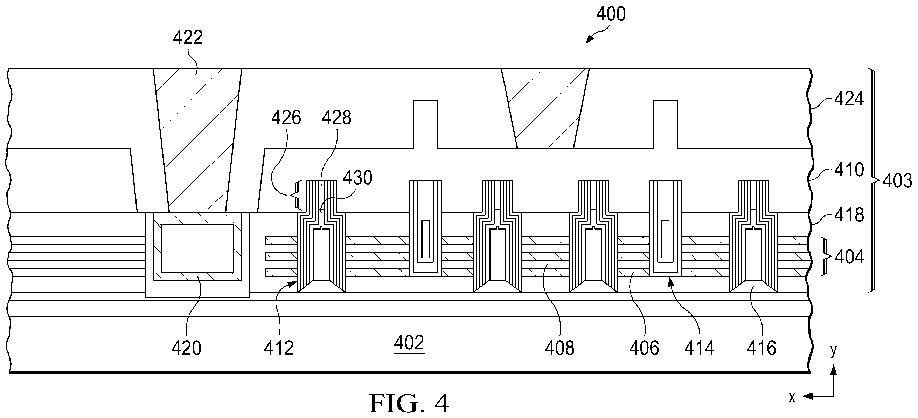

FIG. 4 illustrates a side view of a cross-section of yet another example of 3D memory device 400, according to some embodiments of the present disclosure. 3D memory device 400 is similar to 3D memory device 200 except for the different structures of the upper ends of channel structures 412. It is understood that the details of other same structures in both 3D memory devices 400 and 200 are not repeated for ease of description.

As shown in FIG. 4, each channel structure 412 can include a narrow portion 426. The narrow portion 426 of each channel structure 412 is disposed at an upper end of channel structure 412 and is surrounded laterally by the semiconductor layer 410. The narrow portion 426 of channel structure 412 has a smaller critical dimension than other portions of channel structure 412. For example, the narrow portion 426 of channel structure 412 has a smaller diameter at a lateral plane than other portions of channel structure 412. Each channel structure 412 in FIG. 4 is shown to include narrow portion 426 for illustrative purposes only. In some embodiments, narrow portion 426 is provided in only a subset of the channel structures 412.

3D memory device 400 further includes semiconductor plug 428 disposed at an upper end of channel structure 412. In some embodiments, semiconductor plugs 428 are formed by depositing semiconductor layer 410, such that semiconductor plugs 428 are a part of the semiconductor layer 410. Semiconductor plugs 428 can be composed, for example, of polysilicon.

3D memory device 400 further includes sealing structures 430 disposed at an upper end of channel structure 412. Sealing structure 430 is formed in channel structure 412 to seal a top portion of channel structure 412 to prevent other material used in subsequent processes from entering into channel structure 412, which could adversely affect an electrical property of channel structure 412. In some embodiments, sealing structure 430 includes a dielectric material including, but not limited to, silicon oxide, silicon nitride, silicon oxynitride, or any combination thereof.

In some embodiments, narrow portion 426 can be used for facilitating formation of sealing structures 430 in channel structure 412. In some embodiments, sealing structure 430 can be formed in channel structure 412 without formation of narrow portion 426.

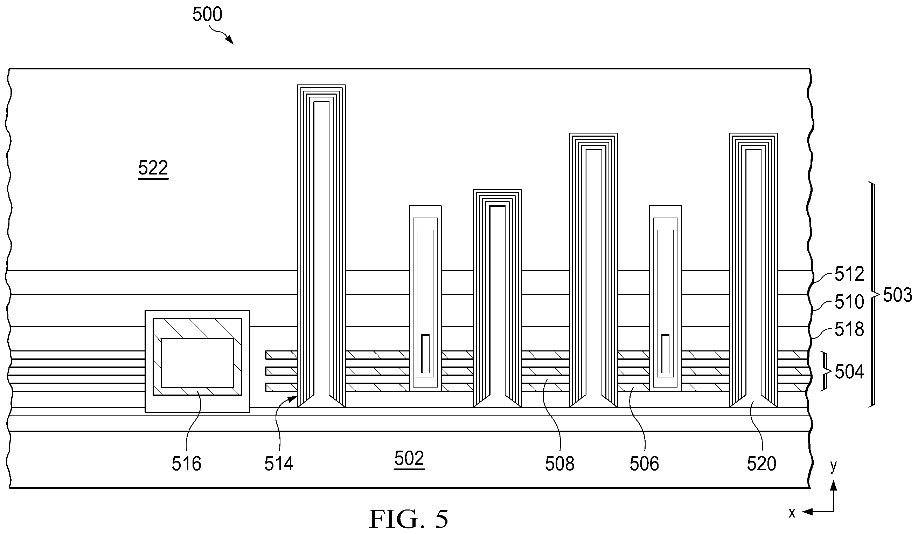

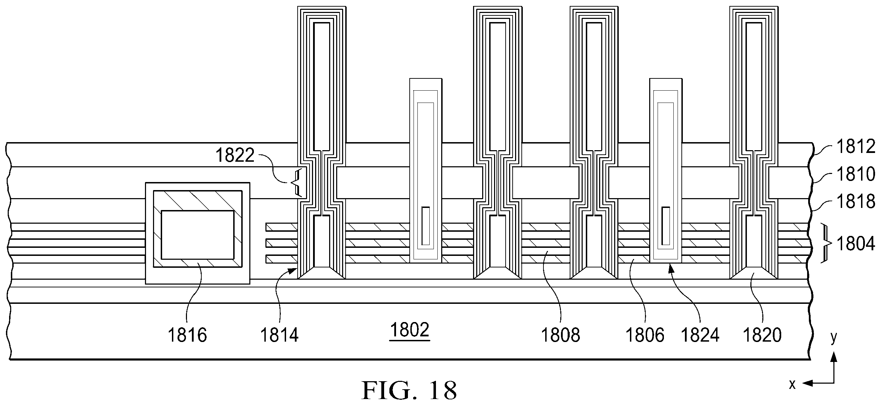

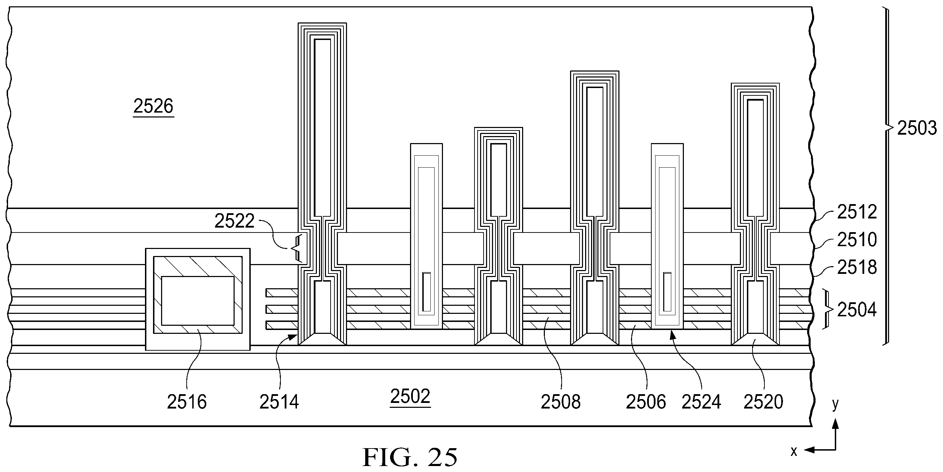

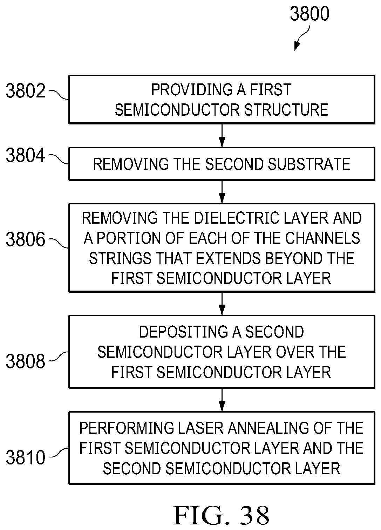

FIGS. 5-17 illustrate a fabrication process for forming example 3D memory devices, according to some examples not forming part of the invention. FIGS. 18-24 illustrate another fabrication process for forming example 3D memory devices, according to some embodiments of the present disclosure. FIGS. 25-37 illustrate yet another fabrication process for forming example 3D memory devices, according to some embodiments of the present disclosure. FIG. 38 illustrates a flowchart of a method 3800 for forming an example 3D memory device, according to some embodiments of the present disclosure. Examples of the 3D memory device depicted in FIGS. 5-38 include 3D memory devices 110, 120, 200, and 400 depicted in FIGS. 1-4. FIG. 38 will be described with reference to FIGS. 5-37 in greater detail below. The operations shown in method 3800 are not exhaustive and that other operations can be performed as well, for example, before, after, or between any of the illustrated operations. Further, some of the operations may be performed simultaneously, or in a different order than shown in FIGS. 5-38.

Referring to FIG. 38, method 3800 starts at operation 3802, in which a semiconductor structure (e.g., semiconductor structure 500 of FIG. 5) is provided. As illustrated in FIG. 5, semiconductor structure 500 includes first structure 502 and second structure 503 stacked over first structure 502. First and second structures 502 and 503 are joined at a bonding interface (not shown), according to some embodiments. First structure 502 can include peripheral circuits. In some embodiments, the peripheral circuits can be any suitable digital, analog, and/or mixed-signal control and sensing circuits used for facilitating the operation of a memory device.

Second structure 503 can be bonded on top of first structure 502 in a face-to-face manner. In some embodiments, first and second structures 502 and 503 can be bonded by hybrid bonding (also known as "metal/dielectric hybrid bonding"), which is a direct bonding technology (e.g., forming bonding between surfaces without using intermediate layers, such as solder or adhesives) and can obtain metal-metal bonding and dielectric-dielectric bonding simultaneously.

In general, second structure 503 includes a multi-layer stacked structure 504, a first semiconductor layer 510 over the multi-layer stacked structure 504, a dielectric layer 512 over the first semiconductor layer 510, and a substrate 522 over the dielectric layer 512. The multi-layer stacked structure 504 includes a plurality of alternately stacked conductive layers 506 and dielectric layers 508. Semiconductor structure 500 further includes a plurality of channel structures 514 penetrating multi-layer stacked structure 504, first semiconductor layer 510, dielectric layer 512, and substrate 522.

As shown in FIG. 5, second structure 503 includes an array of channel structures 514 penetrating through multi-layer stacked structure 504. Conductive layers 506 and dielectric layers 508 of multi-layer stacked structure 504 can alternate in the vertical direction. Conductive layers 506 can include conductive materials including, but not limited to, W, Co, Cu, Al, polysilicon, doped silicon, silicides, or any combination thereof. Each conductive layer 506 can include a gate electrode (gate line) surrounded by an adhesive layer and a gate dielectric layer. The gate electrode of conductive layer 506 can extend laterally as a word line, ending at one or more staircase structures of multi-layer stacked structure 504. Dielectric layers 508 can include dielectric materials including, but not limited to, silicon oxide, silicon nitride, silicon oxynitride, or any combination thereof.

In some embodiments, second structure 503 includes dielectric layer 518 over multi-layer stacked structure 504. Dielectric layer 518 can include dielectric materials including, but not limited to, silicon oxide, silicon nitride, silicon oxynitride, or any combination thereof. In some embodiments, dielectric layer 518 can be a part of multi-layer stacked structure 504.

Second structure 503 further includes semiconductor layer 510 above multi-layer stacked structure 504, such that dielectric layer 518 is disposed between multi-layer stacked structure 504 and semiconductor layer 510. In some embodiments, semiconductor layer 510 can be an amorphous silicon layer formed using one or more thin film deposition processes including, but not limited to, CVD, PVD, ALD, or any combination thereof. In some embodiments, semiconductor layer 510 can be an undoped semiconductor layer. In some embodiments, semiconductor layer 510 can be a doped semiconductor layer (e.g., N-type doped). Semiconductor layer 510 can be doped with any suitable dopants, such as phosphorus (P), arsenic (Ar), or antimony (Sb), which contribute free electrons and increase the conductivity of the intrinsic semiconductor. For example, semiconductor layer 510 may be a polysilicon layer doped with N-type dopant(s), such as P, Ar, or Sb.

In some embodiments, channel structures 514 are similar to channel structures 212, such that each channel structure 514 includes a channel hole filled with a dielectric filler layer 312, a semiconductor channel layer 310, and a channel film 302. In some embodiments, the dielectric filler layer 312 includes dielectric materials, such as silicon oxide. The semiconductor channel layer 310 can include silicon, such as amorphous silicon, polysilicon, or single crystalline silicon. In some embodiments, the channel film 302 is a composite layer including a tunneling layer 308, a storage layer 306 (also known as a "charge trap layer"), and a blocking layer 304. Channel structure 514 can have a cylinder shape (e.g., a pillar shape). The dielectric filler layer 312, semiconductor channel layer 310, tunneling layer 308, storage layer 306, and blocking layer 304 can be arranged radially from the center of channel structure 514 toward the outer surface of the pillar in this order, according to some embodiments. The tunneling layer 308 can include silicon oxide, silicon oxynitride, or any combination thereof. The storage layer 306 can include silicon nitride, silicon oxynitride, silicon, or any combination thereof. The blocking layer 304 can include silicon oxide, silicon oxynitride, high-k dielectrics, or any combination thereof. In one example, the channel film 302 can include a composite layer of silicon oxide/silicon oxynitride/ silicon oxide (ONO).

In some embodiments, channel structure 514 further includes channel plug 520 in the bottom portion (e.g., at the lower end) of channel structure 514. Channel plug 520 can include semiconductor materials (e.g., polysilicon). In some embodiments, channel plug 520 functions as the drain of the NAND memory string.

As shown in FIG. 5, each channel structure 514 can extend vertically through multi-layer stacked structure 504 into substrate 522. The upper end of each channel structure 514 can be below the top surface of substrate 522. That is, channel structure 514 does not extend beyond the top surface of substrate 522, according to some embodiments.

Second structure 503 can further include word line contact 516. Word line contact 516 can include one or more conductive layers, such as a metal layer (e.g., W, Co, Cu, or Al) or a silicide layer surrounded by an adhesive layer (e.g., TiN).

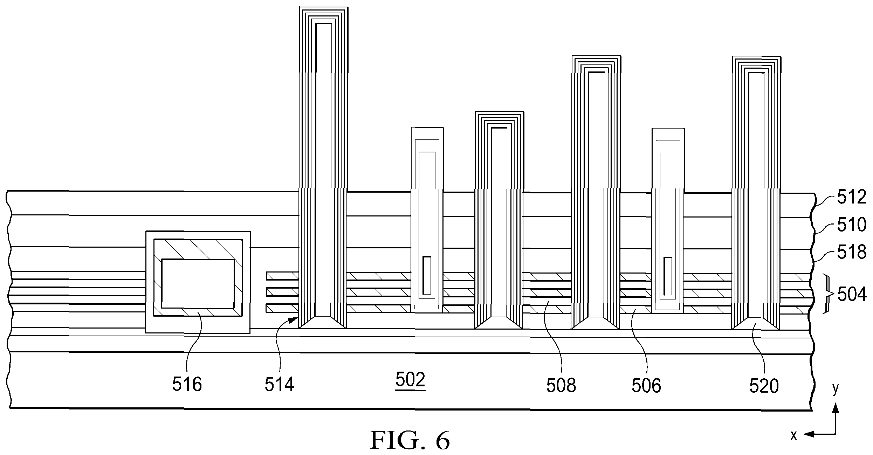

At operation 3804 as shown in FIG. 38, the substrate is removed to expose the dielectric layer. For example, referring to FIG. 6, substrate 522 is removed to expose dielectric layer 512. In some embodiments, substrate 522 can be removed by wet etching and/or dry etching. In some embodiments, substrate 522 is removed by CMP, which can be automatically stopped when reaching dielectric layer 512 composed of materials other than silicon. That is, dielectric layer 512 can act as a CMP/etch stop layer when removing substrate 522 and later when etching the channel structure 514 and, thus, may include any suitable materials other than the material of substrate 522. In some embodiments, substrate 522 can be removed by first performing chemical mechanical polishing (CMP) on substrate 522, followed by low selectivity wet etching and high selectivity wet etching. In some embodiments, substrate 522 can be completely removed such that the channel film 302 of channel structures 514 are exposed. In some embodiments, the etching conditions, such as etching rate and time, can be controlled to ensure that an etching depth can be reached and stopped by dielectric layer 512. In some embodiments, substrate 522 includes silicon (e.g., single crystalline silicon, c-Si), silicon germanium (SiGe), gallium arsenide (GaAs), germanium (Ge), SOI, or any other suitable materials.

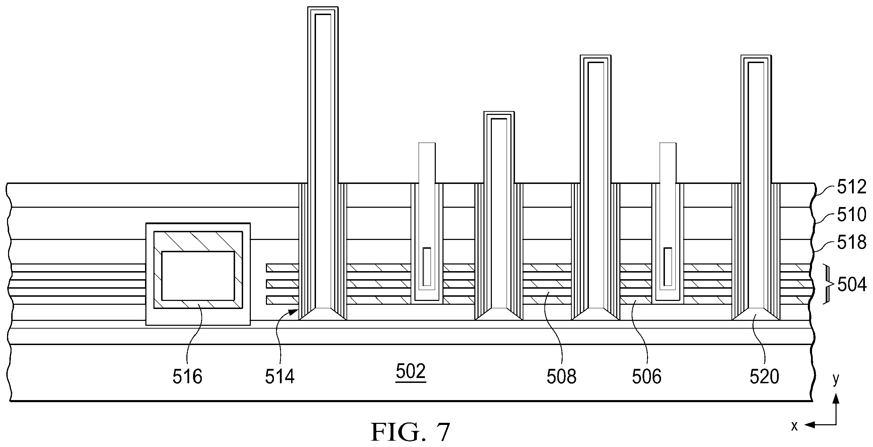

At operation 3806 as shown in FIG. 38, the dielectric layer and a portion of each of the channel structures are removed, such that a remaining portion of a semiconductor channel layer of each channel structure extends beyond the first semiconductor layer, as described below with reference to FIGS. 7-9. Referring to FIG. 7, the remaining portion of second structure 503 can be etched such that a portion of dielectric layer 512 and a portion of the channel film 302 of each channel structure 514 are removed. In some embodiments, channel structures 514 are etched such that the tunneling layer 308, the storage layer 306, and the blocking layer 304 of the channel film 302 of a portion of each channel structure 514 are removed. In some embodiments, as a result of etching channel structures 514, a portion of dielectric layer 512 is also removed, such that the semiconductor channel layer 310 of a portion of channel structures 514 that extends beyond the remaining portion of dielectric layer 512 is exposed. In some embodiments, channel structures 514 and dielectric layer 512 can be etched by controlling the etching time and/or etching rate, such that a desired thickness of dielectric layer 512 can remain over semiconductor layer 510. In some embodiments, channel structures 514 and dielectric layer 512 can be etched by wet etching and/or dry etching. In some embodiments, channel structures 514 and dielectric layer 512 can be etched by gas etching.

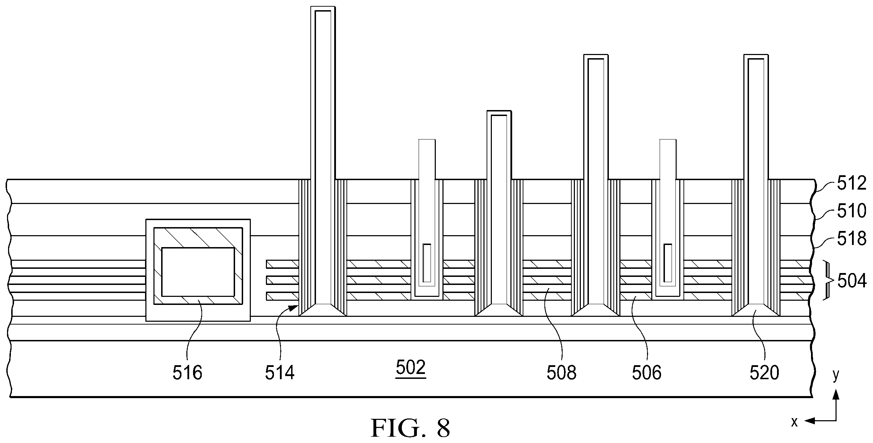

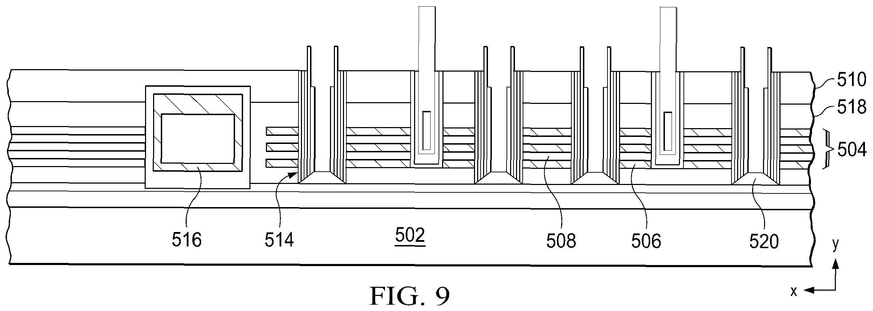

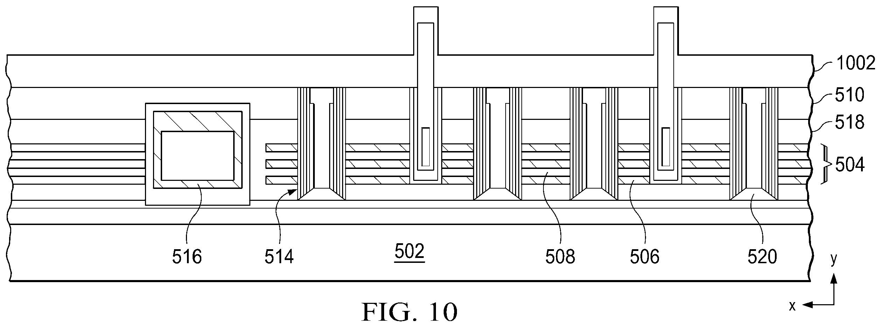

After the channel film 302 of a portion of each channel structure 514 is removed, the semiconductor channel layer 310 of the portion of each channel structure 514 that extends beyond the remaining portion of dielectric layer 512 is removed (FIG. 8). In some embodiments, the portion of the semiconductor channel layer 310 of each channel structure 514 that extends beyond the remaining portion of dielectric layer 512 is removed by wet etching and/or dry etching. In some embodiments, the portion of the semiconductor channel layer 310 of each channel structure 514 that extends beyond the remaining portion of dielectric layer 512 is removed by gas etching. In some embodiments, the dielectric filler layer 312 of each channel structure 514 is exposed as a result of etching the semiconductor channel layer 310 of each channel structure 514. The remaining portion of dielectric layer 512 can be used to reserve a portion of semiconductor channel layer 310 of channel structure 514 that extends beyond semiconductor layer 510 (see e.g., FIG. 9), which can be used in subsequent processes for connection with another semiconductor layer (e.g., semiconductor layer 1002 in FIG. 10) and to prevent external material from entering into channel structure 514.

Referring to FIG. 9, after the semiconductor channel layers 310 of channel structures 514 are etched, the dielectric filler layers 312 of channel structures 514 and dielectric layer 512 are etched such that the remaining portion of dielectric layer 512 is removed to expose semiconductor layer 510, and that a remaining portion of the semiconductor channel layer 310 of each channel structure 514 extends beyond semiconductor layer 510 and a remaining portion of the dielectric filler layer 312 of each channel structure 514 extends only partially through semiconductor layer 510. For example, a top surface of the semiconductor channel layer 310 of channel structure 514 may extend beyond a top surface of semiconductor layer 510, and a top surface of the dielectric filler layer 312 of channel structure 514 may extend only below the top surface of semiconductor layer 510. The remaining portion of the semiconductor channel layer 310 of each channel structure 514 extends beyond semiconductor layer 510 can be used for connection with a semiconductor layer (e.g., semiconductor layer 1002 in FIG. 10) deposited in a subsequent process and to prevent external material from entering into channel structure 514. In some embodiments, the dielectric filler layers 312 of channel structures 514 can be etched by wet etching and/or dry etching. In some embodiments, the dielectric filler layers 312 of channel structures 514 can be etched by gas etching.

At operation 3808 as shown in FIG. 38, a second semiconductor layer is deposited over the first semiconductor layer. Referring to FIG. 10, semiconductor layer 1002 is deposited over semiconductor layer 510. Semiconductor layer 1002 can be deposited on semiconductor layer 510 using one or more thin film deposition processes including, but not limited to, CVD, PVD, ALD, or any combination thereof, according to some embodiments. In some embodiments, semiconductor layer 1002 can be deposited using CVD so that the deposited semiconductor material will not enter into the channel structures. In some embodiments, semiconductor layer 1002 includes an amorphous silicon layer. In some embodiments, semiconductor layer 1002 includes a doped semiconductor layer. In some embodiments, to form N-type doped semiconductor layer, semiconductor layer 1002 is deposited on semiconductor layer 510 using one or more thin film deposition processes including, but not limited to, CVD, PVD, ALD, or any combination thereof followed by doping the deposited semiconductor layer 1002 with N-type dopant(s), such as P, As or Sb, using ion implantation and/or thermal diffusion. In some embodiments, to form N-type doped semiconductor layer, in-situ doping of N-type dopants, such as P, As, or Sb, is performed when depositing semiconductor layer 1002 on semiconductor layer 510.

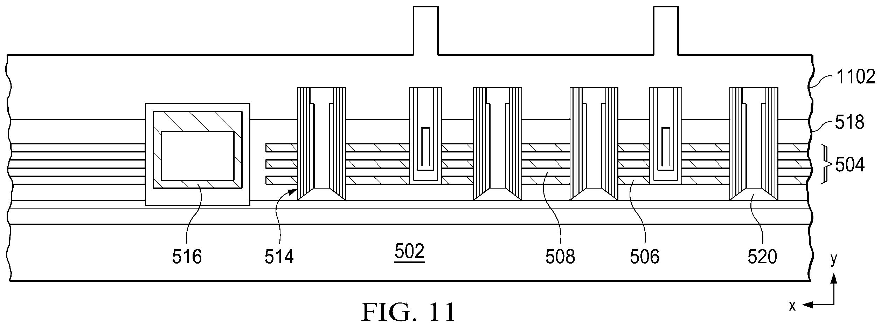

In some embodiments, laser annealing is performed on semiconductor layer 1002 and semiconductor layer 510 to generate composite semiconductor layer 1102 (FIG. 11). In some embodiments, composite semiconductor layer 1102 comprises crystalline silicon. In some embodiments, a remaining portion of each channel structure 514 penetrates into composite semiconductor layer 1102. In one example, the remaining portion of each channel structure 514 does not penetrate through composite semiconductor layer 1102. In some embodiments, semiconductor channel layers 310 of channel structures 514 and the composite semiconductor layer 1102 can include a same material such that semiconductor channel layers 310 of channel structures 514 and the composite semiconductor layer 1102 do not have a clearly defined boundary separating them from one another.

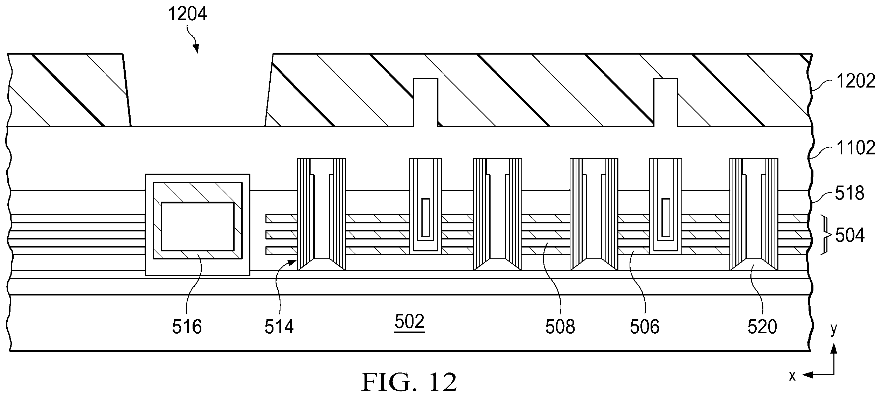

After forming composite semiconductor layer 1102 and etching channel structures 514 to shorten channel structures 514 and align the top surface of each channel structure 514, another dielectric layer may be deposited over the composite semiconductor layer 1102 and lead-out contacts may be formed penetrating the deposited dielectric layer, as described with reference to FIG. 12-17.

Referring to FIG. 12, in some embodiments, photoresist layer 1202 is deposited over composite semiconductor layer 1102, and trench 1204 is formed penetrating through photoresist layer 1202. In some embodiments, a photolithography process can be performed over composite semiconductor layer 1102 to form photoresist layer 1202 and trench 1204. In some embodiments, trench 1204 is disposed over contact 516.

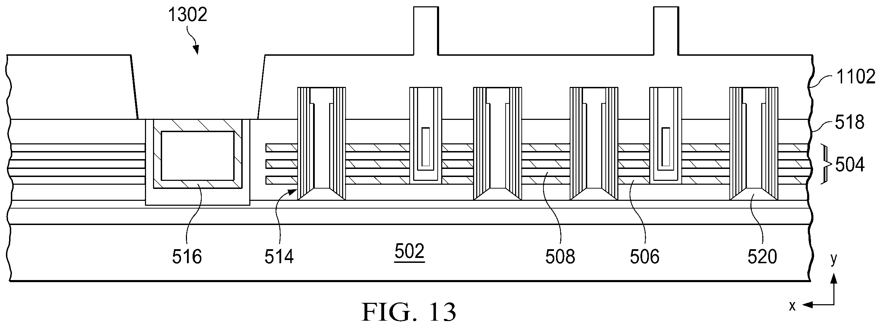

Then, as indicated by FIG. 13, trench 1302 can be patterned and formed based on photoresist layer 1202 and trench 1204. Trench 1302 can be formed by etching through composite semiconductor layer 1102 using wet etching and/or dry etching. In some embodiments, the etching of semiconductor layer 1102 to form trench 1302 can stop at the bottom surface of composite semiconductor layer 1102 or the top surface of dielectric layer 518.

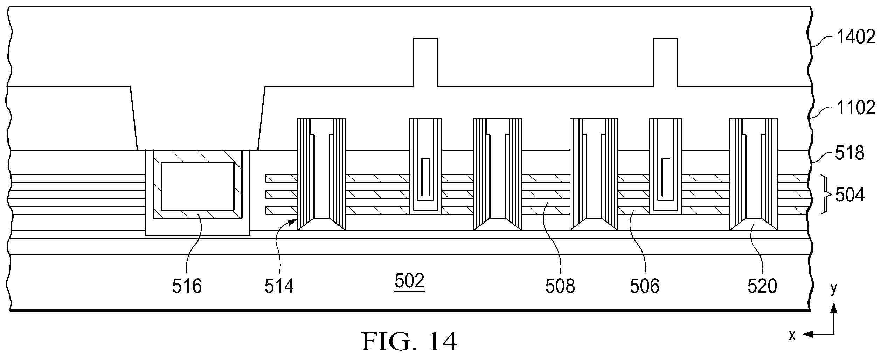

Next, as indicated by FIG. 14, dielectric layer 1402 is deposited over composite semiconductor layer 1102. In some embodiments, dielectric layer 1402 can be formed by depositing dielectric materials, such as silicon oxide or silicon nitride, using one or more thin film deposition processes, such as CVD, PVD, ALD, or any combination thereof. In some embodiments, trench 1302 is filled by a material of dielectric layer 1402. In some embodiments, a CMP process can be performed on the dielectric layer 1402 to planarize a top surface of dielectric layer 1402.

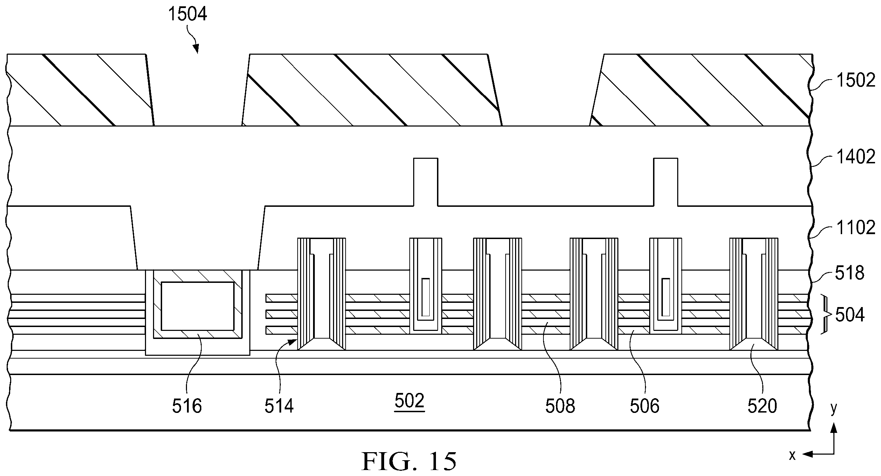

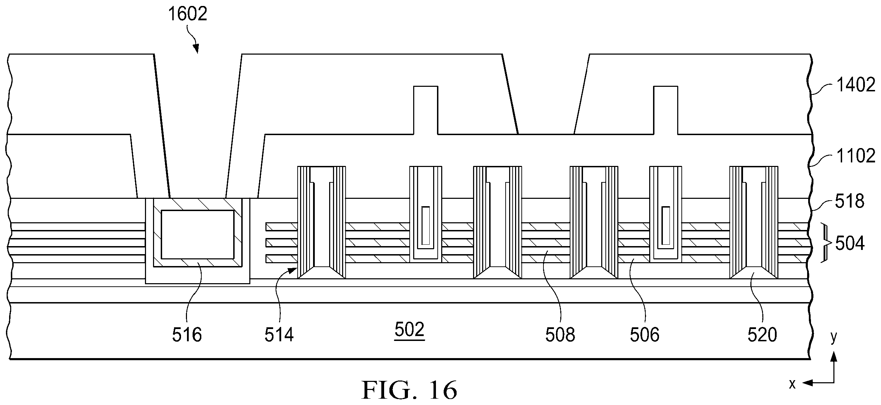

After planarizing the top surface of dielectric layer 1402, photoresist layer 1502 is deposited over dielectric layer 1402, and trenches 1504 are formed penetrating through photoresist layer 1502 (FIG. 15). In some embodiments, a photolithography process can be performed over dielectric layer 1402 to form photoresist layer 1502 and trenches 1504. In some embodiments, at least one trench 1504 is disposed over filled trench 1302. Then, trenches 1602 are formed penetrating dielectric layer 1402 based on photoresist layer 1502 and trenches 1504 (FIG. 16). In some embodiments, trench 1602 can penetrate through the portion of dielectric layer 1402 that penetrates through semiconductor layer 1102 and stop at a top surface of dielectric layer 518.

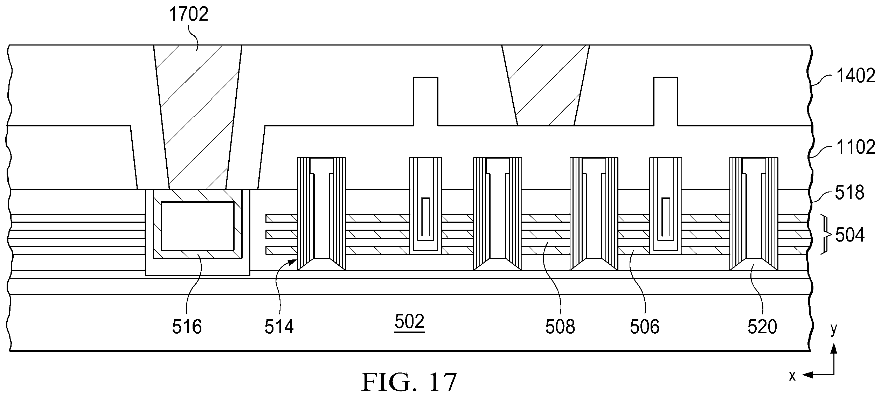

Referring to FIG. 17, trenches 1602 are filled with a conductive material to form lead-out contact 1702. In some embodiments, one or more conductive materials are deposited into trenches 1602 using one or more thin film deposition processes, such as ALD, CVD, PVD, any other suitable processes, or any combination thereof, to fill trenches 1602 with an adhesive layer ( e.g., TiN) and a conductor layer (e.g., W). In some embodiments, a planarization process, such as CMP, can then be performed to remove the excess conductive materials over the top surfaces of contacts 1702 and the top surface of dielectric layer 1402.

In some implementations, the manufacturing process as described herein can make the dielectric layer formed over the semiconductor layer (e.g., composite semiconductor layer 1102) thinner. Further, in some implementations, it also can reduce the aspect ratio of the lead-out contacts that are subsequently formed penetrating the semiconductor layer, which can expand the range of materials for the lead-out contact, thereby eliminating an additional step of forming connection for the lead-out contact. In some cases, such features can also lift the restriction on the formation position of the lead-out contacts due to the different depths of gate slit lines, and reduce the difficulty of a subsequent CMP process. As a result, the complexity and cost of the fabrication process can be reduced, and the product yield can be increased in some cases.

In some embodiments, a sealing structure can be formed in a channel structure at a top portion of the channel structure to prevent other material used in subsequent processes from entering into the channel structure, which otherwise may adversely affect an electrical property of the channel structure. A manufacturing process including forming such a seal structure is described below with reference to FIGS. 18-24.

The structure in FIG. 18 is similar to the structure in FIG. 6 except for the removed substrate and a narrow portion of the channel structures. The narrow portion can be formed during formation of the channel structures and/or the manufacturing process of the 3D memory device. The details of other structures that are the same or similar in FIGS. 6 and 18 are not repeated for ease of description. In some embodiments, a substrate (not shown) disposed over dielectric layer 1812 is removed to expose dielectric layer 1812. In some embodiments, the substrate can be removed by using wet etching and/or dry etching. In some embodiments, the substrate is removed using CMP, which can be automatically stopped when reaching dielectric layer 1812 composed of materials other than silicon. In some embodiments, the substrate can be removed by first performing CMP on the substrate, followed by low selectivity wet etching and high selectivity wet etching.

As shown, multi-layer stacked structure 1804 including alternately stacked conductive layers 1806 and dielectric layers 1808 is disposed over structure 1802. In some embodiments, structure 1802 can include peripheral circuits. Channel structure 1814 penetrating multi-layer stacked structure 1804 can each include a narrow portion 1822. In some embodiments, narrow portion 1822 can be located within semiconductor layer 1810 such that narrow portion 1822 is laterally surrounded by semiconductor layer 1810. Note that each channel structure 1814 in FIG. 18 is shown to include narrow portion 1822 for illustrative purpose only. In some embodiments, narrow portion 1822 is formed in only a subset of the channel structures 1814. In some embodiments, narrow portion 1822 may not be formed in any of channel structures 1814.

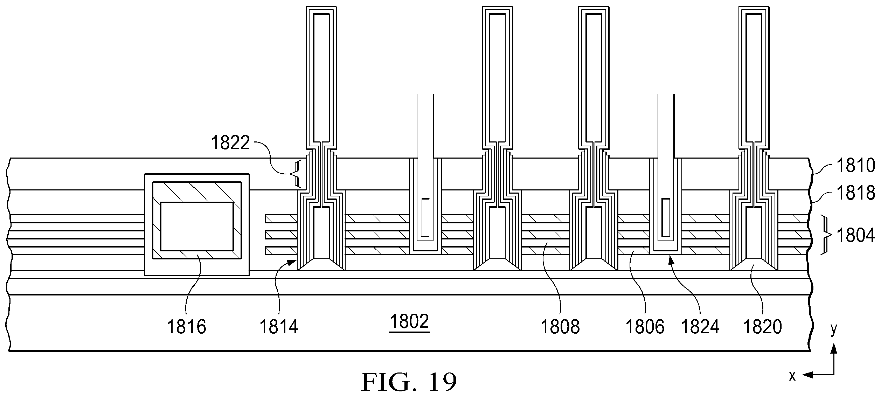

Referring to FIG. 19, dielectric layer 1812 and channel film of a portion of each channel structure 1814 that extends beyond semiconductor layer 1810 are removed. In some embodiments, channel structures 1814 are etched such that the tunneling layer, the storage layer, and the blocking layer of the channel film 302 of a portion of each channel structure 1814 that extends beyond semiconductor layer 1810 are removed. In some embodiments, as a result of etching channel structures 1814, dielectric layer 1812 is also removed. In some embodiments, channel structures 1814 and dielectric layer 1812 can be etched by controlling the etching time and/or etching rate, such that an etching depth can stop at a top surface of semiconductor layer 1810. In some embodiments, channel structures 1814 and dielectric layer 1812 can be etched by wet etching and/or dry etching.

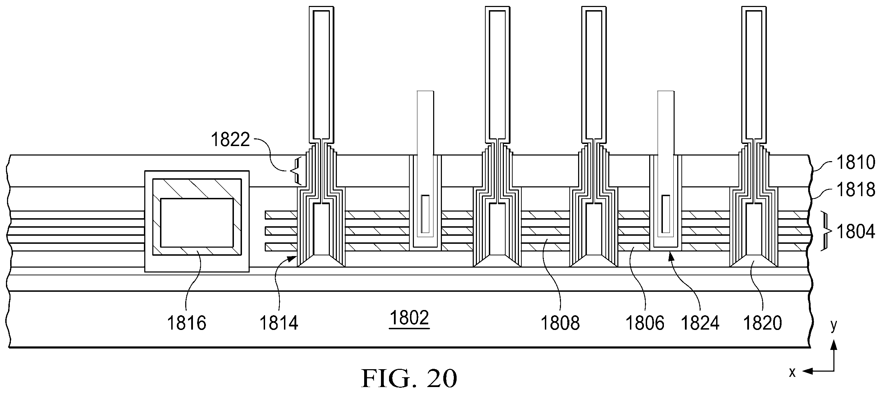

Then, the semiconductor channel layer 310 of a portion of each channel structure 1814 that extends beyond semiconductor layer 1810 is removed (FIG. 20). In some embodiments, the semiconductor channel layer 310 of a portion of each channel structure 1814 that extends beyond semiconductor layer 1810 can be removed by wet etching and/or dry etching. In some embodiments, the dielectric filler layer 312 of each channel structure 1814 is exposed as a result of etching the semiconductor channel layer 310 of each channel structure 1814.

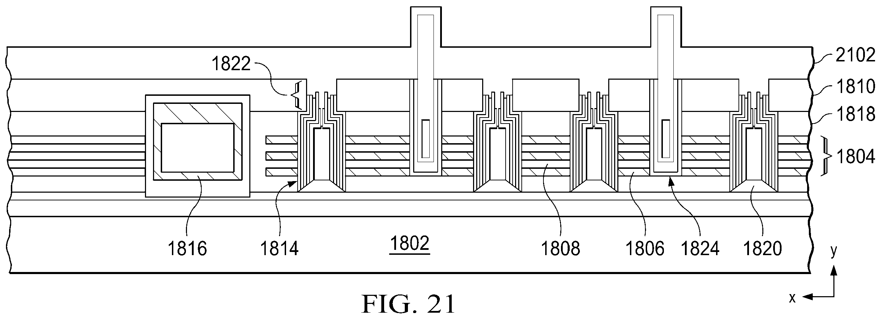

Next, dielectric layer 2102 is deposited over semiconductor layer 1810 (FIG. 21). In some embodiments, dielectric layer 2102 can be formed by depositing silicon oxide, using one or more thin film deposition processes, such as ALD, CVD, PVD, any other suitable processes, or any combination thereof. In one example, dielectric layer 2102 is formed by depositing silicon oxide using ALD when the dimension of channel structures 1814 is small so that using CVD and PVD may achieve a sub-optimal result. In some embodiments, the dielectric filler layer 312 of a portion of each channel structure 1814 that extends beyond semiconductor layer 1810 can be removed as a result of depositing dielectric layer 2102. In some embodiments, a portion of dielectric layer 2102 can penetrate into a top portion of channel structure 1814, such that the portion of dielectric layer 2102 penetrating into the top portion of channel structure 1814 is laterally surrounded by the dielectric filler layer 312 of channel structure 1814. In some embodiments, a portion of dielectric layer 2102 penetrating channel structure 1814 can be surrounded laterally by the narrow portion 1822 of channel structure 1814.

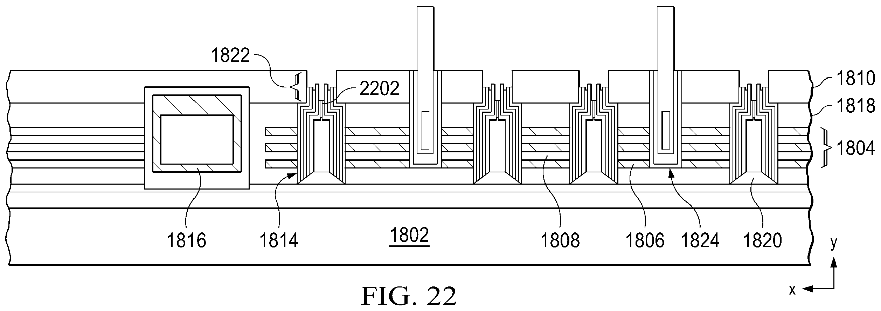

Referring to FIG. 22, dielectric layer 2102 is etched by wet etching and/or dry etching. In some embodiments, the etching conditions, such as etching rate and time, can be controlled to form sealing structure 2202 in channel structure 1814. In some embodiments, sealing structure 2202 includes a material of a portion sealing structure 2202 that remains in the channel structure 1814 after etching dielectric layer 2102. Sealing structure 2202 is formed in channel structure 1814 to seal a top portion of channel structure 1814 to prevent other material used in subsequent processes from entering into channel structure 1814, which otherwise may adversely affect an electrical property of channel structure 1814.

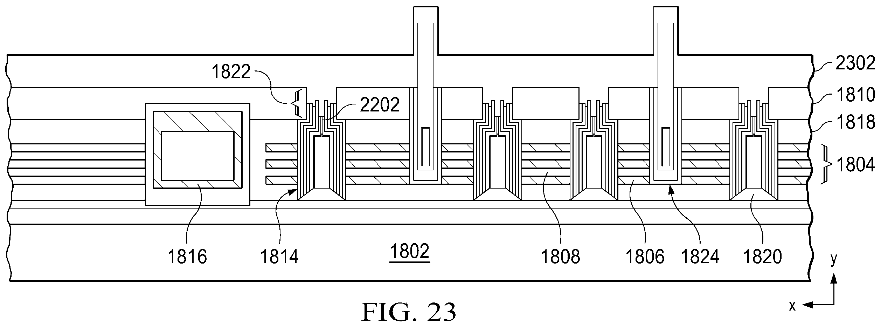

After forming sealing structure 2202, semiconductor layer 2302 is deposited over semiconductor layer 1810 (FIG. 23). Semiconductor layer 2302 can be deposited on semiconductor layer 1810 using one or more thin film deposition processes including, but not limited to, CVD, PVD, ALD, or any combination thereof, according to some embodiments. In some embodiments, semiconductor layer 2302 includes an amorphous silicon layer. In some embodiments, semiconductor layer 2302 includes a doped semiconductor layer. In some embodiments, to form N-type doped semiconductor layer, semiconductor layer 2302 is deposited on semiconductor layer 1810 using one or more thin film deposition processes including, but not limited to, CVD, PVD, ALD, or any combination thereof followed by doping the deposited semiconductor layer 2302 with N-type dopant(s), such as P, As or Sb, using ion implantation and/or thermal diffusion. In some embodiments, to form N-type doped semiconductor layer, in-situ doping of N-type dopants, such as P, As, or Sb, is performed when depositing semiconductor layer 2302 on semiconductor layer 1810.

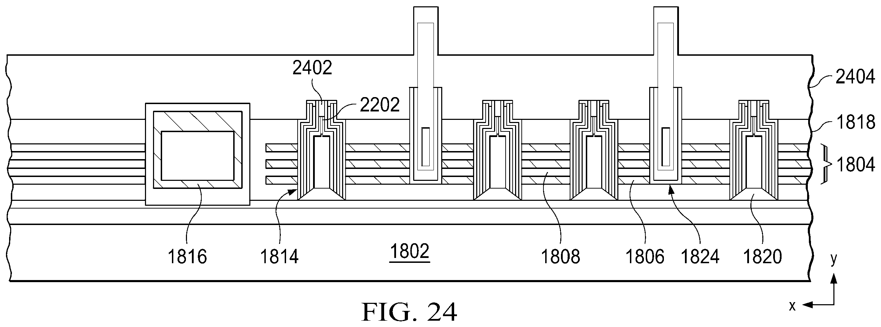

Then, laser annealing can be performed on semiconductor layer 2302 and semiconductor 1810 to form composite semiconductor layer 2404 (FIG. 24). In some embodiments, composite semiconductor layer 2404 comprises crystalline silicon. In some embodiments, a remaining portion of each of the channel structures 1814 penetrates into composite semiconductor layer 2404.

In some embodiments, semiconductor plug 2402 is formed at an upper end of channel structure 1814. In some embodiments, semiconductor plug 2402 is formed as a result of depositing semiconductor layer 2302 and forming composite semiconductor layer 2404, such that semiconductor plug 2402 is a part of composite semiconductor layer 2404.

The structure as shown in FIG. 24 can be further processed in a similar way as the processes described with reference to FIGS. 12-17; the details of such subsequent steps are not repeated here for ease of description.

The manufacturing process as described herein can include forming a sealing structure in a channel structure at a top portion of the channel structure to prevent other material used in subsequent processes from entering into channel structure, which otherwise may adversely affect an electrical property of the channel structure. As a result, the complexity and cost of the fabrication process can be reduced, the product yield can be increased, and the performance of the product can be improved in some cases.

In some embodiments, during the manufacturing process, e.g., when etching the channel films of the channel structure, some channel structures may have a risk of collapsing due to their height. To mitigate the risk of collapsing, etching the channel structures to remove a portion of the channel structures that extends beyond the semiconductor layer can be done in multiple stages. In general, in a first stage, after removing the substrate, a blocking layer can be deposited over the dielectric layer which is over the multi-layer stacked structure. The blocking layer can be used as a stop layer to etch the channel structures such that only a portion of each channel structure that extends beyond the blocking layer can be removed. In a second stage, the blocking layer can be removed, and the remaining portion of each channel structure that extends beyond the dielectric layer can be removed. The multi- (e.g., two-) stage etching process is discussed in greater detail with reference to FIGS. 25-37.

The structure in FIG. 25 is similar to the structure in FIG. 6 except for a narrow portion of the channel structures. The details of other structures that are the same or similar in FIGS. 6 and 25 are not repeated for ease of description. As shown in FIG. 25, multi-layer stacked structure 2504 including alternately stacked conductive layers 2506 and dielectric layers 2508 is disposed over structure 2502. In some embodiments, structure 2502 can include peripheral circuits. Channel structures 2514 penetrating through multi-layer stacked structure 2504 into substrate 2526 can each include a narrow portion 2522. In some embodiments, narrow portion 2522 can be located within semiconductor layer 2510 such that narrow portion 2522 is laterally surrounded by semiconductor layer 2510. Each channel structure 2514 in FIG. 25 is shown to include narrow portion 2522 for illustrative purposes only. In some embodiments, narrow portion 2522 is formed in only a subset of the channel structures 2514. In some embodiments, narrow portion 2522 may not be formed in any of channel structures 2514.

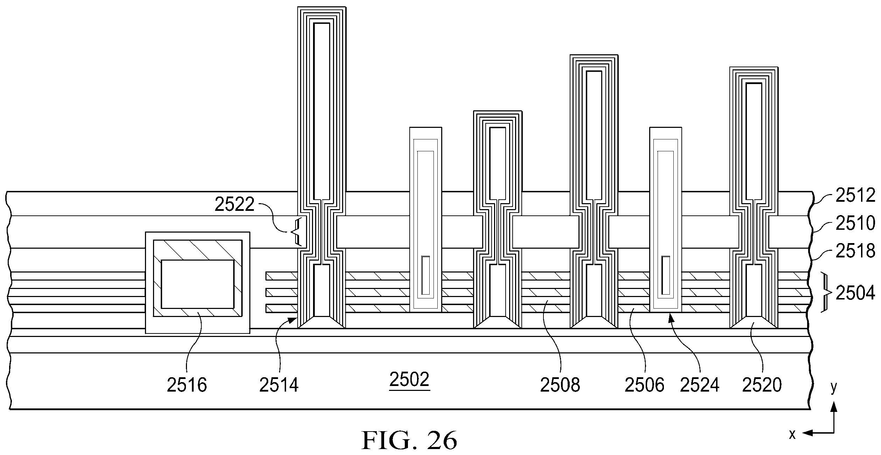

Referring to FIG. 26, substrate 2526 is removed to expose dielectric layer 2512. In some embodiments, substrate 2526 can be removed by wet etching and/or dry etching. In some embodiments, substrate 2526 is removed by CMP, which can be automatically stopped when reaching dielectric layer 2512 composed of materials other than silicon. In some embodiments, substrate 2526 can be removed by first performing CMP on the substrate, followed by low selectivity wet etching and high selectivity wet etching. As a result of removing substrate 2526, a portion of each channel structure 2514 that extends beyond dielectric layer 2512 is exposed.

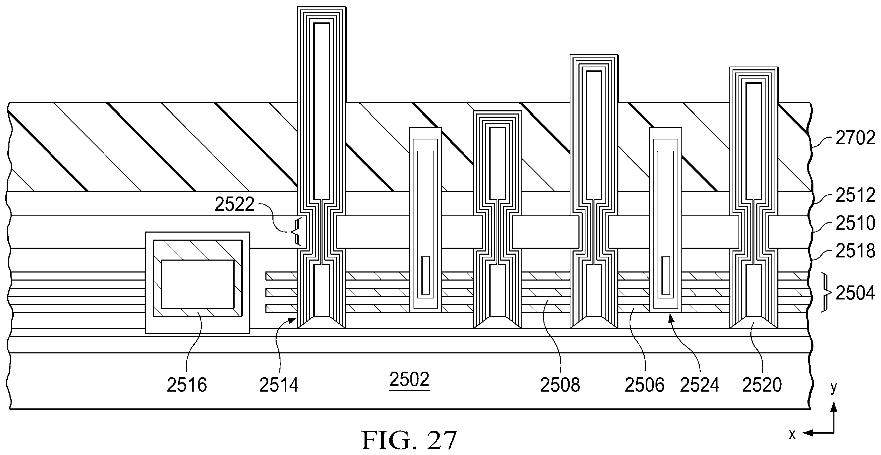

Then, blocking layer 2702 is deposited over dielectric layer 2512 (FIG. 27). In some embodiments, blocking layer 2702 is deposited using one or more thin film deposition processes including, but not limited to, CVD, PVD, ALD, or any combination thereof. In some embodiments, blocking layer 2702 includes a dielectric material, such as silicon oxide, silicon nitride, etc. In some embodiments, blocking layer 2702 can include a photoresist material. In some embodiments, blocking layer 2702 and dielectric layer 2512 are composed of the same material. In some embodiments, blocking layer 2702 and dielectric layer 2512 are composed of different materials. In some embodiments, blocking layer 2702 can be deposited such that only a subset of channel structures 2514 extend beyond blocking layer 2702. In some embodiments, a subset of channel structures 2514 may not extend beyond blocking layer 2702 such that a top surface of each of the subset of channel structures 2514 is below a top surface of blocking layer 2702.

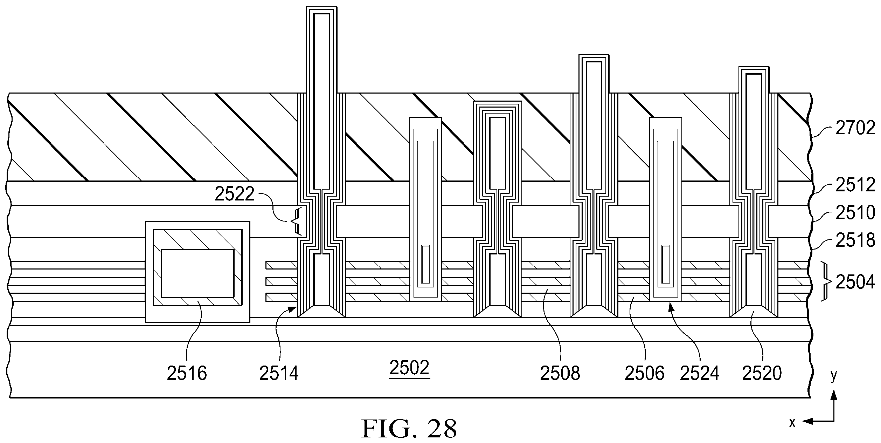

Next, channel film 302 of a portion of each channel structure 2514 that extends beyond blocking layer 2702 is removed (FIG. 28). In some embodiments, channel films 302 of channel structures 2514 can be removed by wet etching and/or dry etching. In some embodiments, channel structures 2514 are etched such that the tunneling layer, the storage layer, and the blocking layer of the channel film 302 of a portion of each channel structure 2514 that extends beyond blocking layer 2702 are removed. In some embodiments, the semiconductor channel layers 310 of channel structures 2514 can be exposed as a result of removing channel films 302 of channel structures 2514.

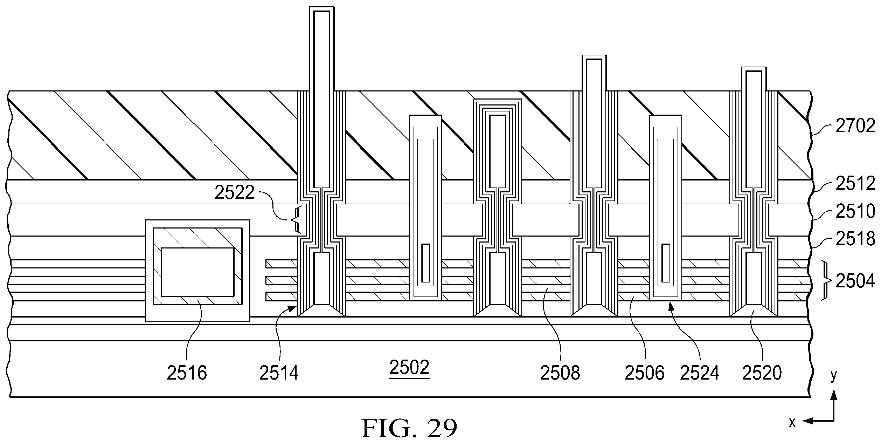

Referring to FIG. 29, the semiconductor channel layer 310 of a portion of each channel structure 2514 that extends beyond blocking layer 2702 is removed. In some embodiments, the semiconductor channel layer 310 of a portion of each channel structure 2514 that extends beyond blocking layer 2702 can be removed by wet etching and/or dry etching. In some embodiments, the dielectric filler layer 312 of each channel structure 2514 is exposed as a result of removing the semiconductor channel layer 310 of each channel structure 2514.

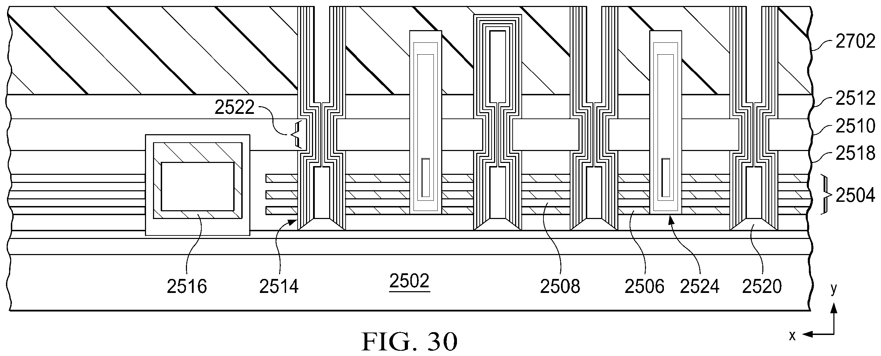

Then, the dielectric filler layer 312 of a portion of each channel structure 2514 that extends beyond blocking layer 2702 is removed (FIG. 30). In some embodiments, the dielectric filler layer 312 of a portion of each channel structure 2514 that extends beyond blocking layer 2702 can be removed by wet etching and/or dry etching.

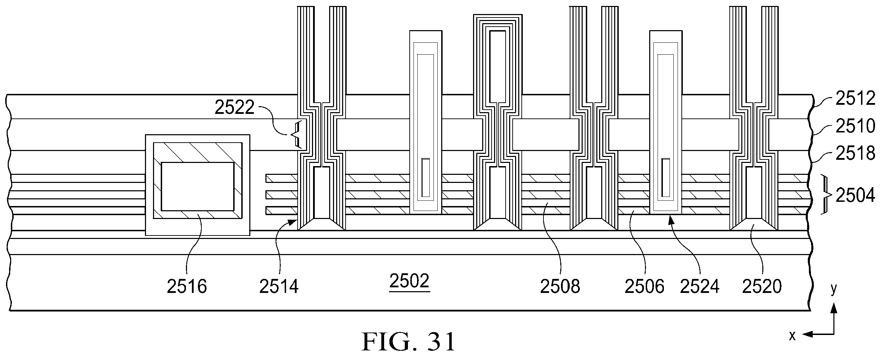

Next, the remaining portion of blocking layer 2702 can be removed to expose dielectric layer 2512 (FIG. 31). In some embodiments, the remaining portion of blocking layer 2702 can be removed by wet etching and/or dry etching. In some embodiments, the etching conditions, such as etching rate and time, can be controlled to stop the etching at a top surface of dielectric layer 2512. In some embodiments, as a result of removing the remaining portion of blocking layer 2702, a portion of each channel structure 2514 that extends beyond dielectric layer 2512 can be exposed.

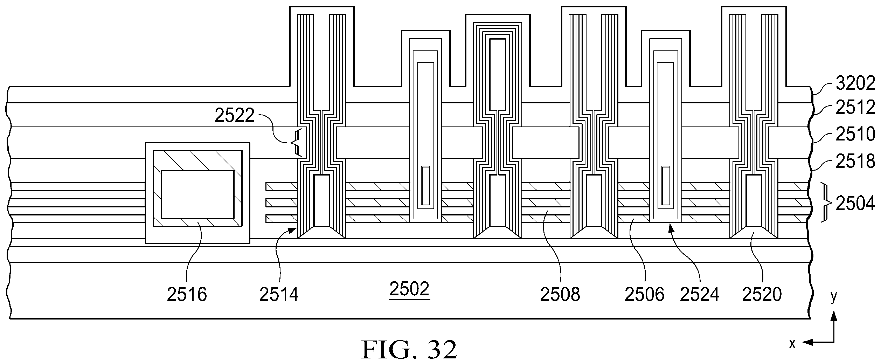

Referring to FIG. 32, dielectric layer 3202 is deposited over dielectric layer 2512. In some embodiments, dielectric layer 3202 is deposited using one or more thin film deposition processes including, but not limited to, CVD, PVD, ALD, or any combination thereof. In some embodiments, dielectric layer 3202 and dielectric layer 2512 are composed of the same material. In some embodiments, dielectric layer 3202 and dielectric layer 2512 are composed of different materials. In some embodiments, dielectric layer 3202 includes silicon oxide. In some embodiments, channel structures 2514 can be partially filled with a material of dielectric layer 3202 as a result of depositing dielectric layer 3202. The material of dielectric layer 3202 that partially fills channel structures 2514 can be used to stabilize and increase resilience of channel structures 2514, such that when in subsequent steps the channel films 302 of channel structures 2514 are removed, the remaining portions (e.g., semiconductor channel layer 310 and dielectric filler layer 312) of channel structures 2514 do not collapse.

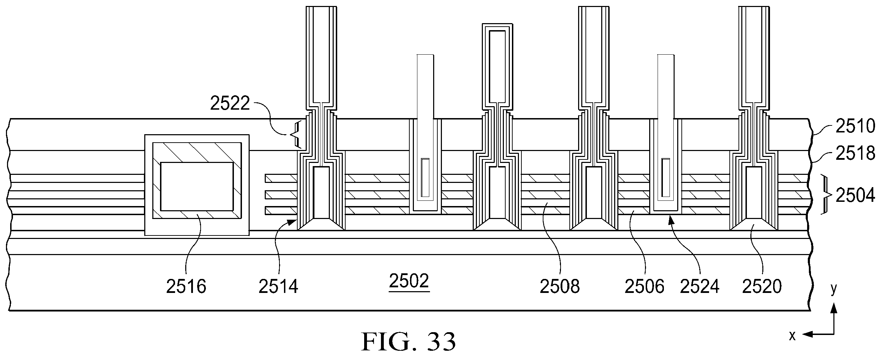

Then, dielectric layer 3202 is etched (FIG. 33) such that a portion of dielectric layer 3202 over semiconductor layer 2510 and a portion of dielectric layer 3202 covering an outer surface of channel structures 2514 are removed. Furthermore, as a result of etching dielectric layer 3202, dielectric layer 2512 and channel film 302 of a portion of each channel structure 2514 that extends beyond semiconductor layer 2510 is also removed. In some embodiments, the tunneling layer, the storage layer, and the blocking layer of the channel film 302 of a portion of each channel structure 2514 that extends beyond semiconductor layer 2510 are removed. In some embodiments, the material of dielectric layer 3202 that partially fills channel structures 2514 is not affected by etching dielectric layer 3202 and thus remains partially filling channel structures 2514.

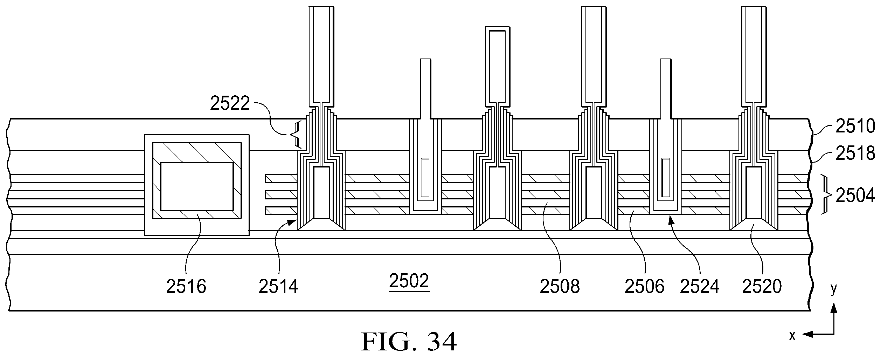

Next, the semiconductor channel layer 310 of a portion of each channel structure 2514 that extends beyond semiconductor layer 2510 is removed (FIG. 34). In some embodiments, the semiconductor channel layer 310 of a portion of each channel structure 2514 that extends beyond semiconductor layer 2510 can be removed by wet etching and/or dry etching. In some embodiments, the dielectric filler layer 312 of each channel structure 2514 is exposed as a result of etching the semiconductor channel layer 310 of each channel structure 2514.

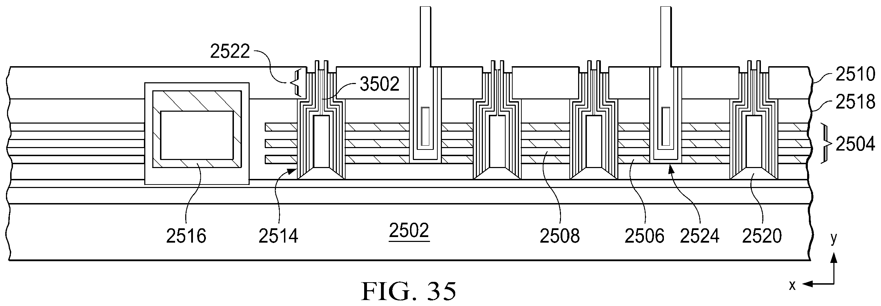

Referring to FIG. 35, the dielectric filler layer 312 of a portion of each channel structure 2514 that extends beyond semiconductor layer 2510 can be removed. In some embodiments, the material of dielectric layer 3202 that partially fills channel structures 2514 is also removed as a result of removing the dielectric filler layer 312 of a portion of each channel structure 2514 that extends beyond semiconductor layer 2510. In some embodiments, as a result of removing the dielectric filler layer 312 of the portion of each channel structure 2514, sealing structure 3502 is formed as a remaining portion of dielectric layer 3202 to seal channel structure 2514. In one example, sealing structure 3502 is formed in channel structure 2514 to seal a top portion of remaining channel structure 2514 to prevent other material used in subsequent processes from entering into channel structure 2514, which otherwise may adversely affect an electrical property of channel structure 2514. In some embodiments, for channel structures 2514 that do not penetrate into blocking layer 2702, sealing structure 3502 can be also formed in those channel structures 2514 to prevent other material used in subsequent processes from entering into channel structure 2514.

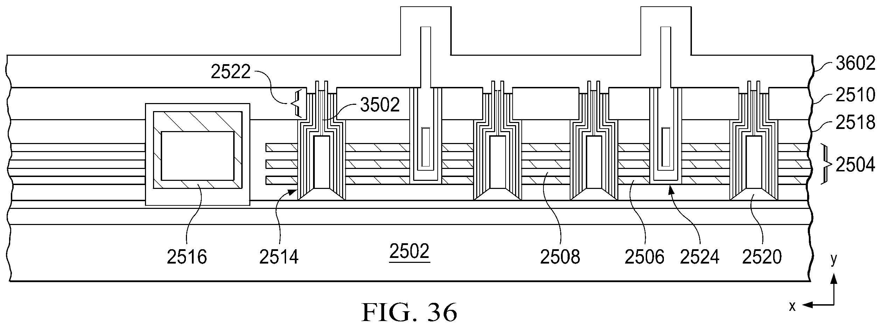

Then, semiconductor layer 3602 is deposited over semiconductor layer 2510 (FIG. 36). Semiconductor layer 3602 can be deposited on semiconductor layer 2510 using one or more thin film deposition processes including, but not limited to, CVD, PVD, ALD, or any combination thereof, according to some embodiments. In some embodiments, semiconductor layer 3602 can include an amorphous semiconductor layer. In some embodiments, semiconductor layer 3602 can include an undoped semiconductor layer. In some embodiments, semiconductor layer 3602 can include a doped semiconductor layer. In some embodiments, to form N-type doped semiconductor layer 3602, semiconductor layer 3602 is deposited on semiconductor layer 2510 using one or more thin film deposition processes including, but not limited to, CVD, PVD, ALD, or any combination thereof followed by doping the deposited semiconductor layer 3602 with N-type dopant(s), such as P, As or Sb, using ion implantation and/or thermal diffusion. In some embodiments, to form N-type doped semiconductor layer, in-situ doping of N-type dopants, such as P, As, or Sb, is performed when depositing semiconductor layer 3602 on semiconductor layer 2510.

In some embodiments, after dielectric layer 3202 is etched as shown in FIG. 33, and if the height of channel structures 2514 is short enough so that channel structures 2514 would not collapse on themselves, the steps described with reference to FIGS. 34-35 may be skipped, and semiconductor layer 3602 may be deposited over semiconductor layer 2510 following the steps as described in FIG. 33.

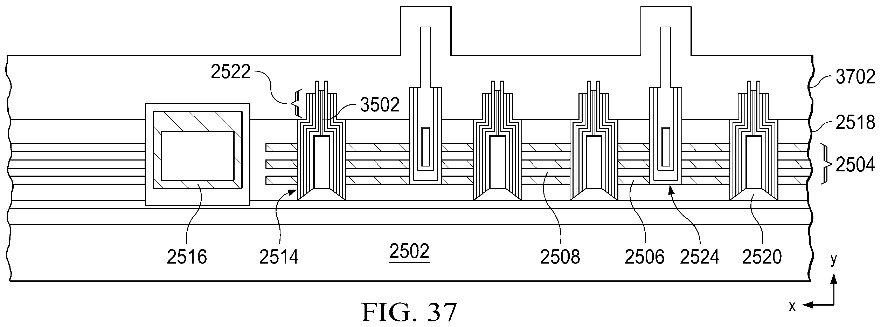

Next, laser annealing can be performed on semiconductor layer 3602 and semiconductor 2510 to generate composite semiconductor layer 3702 (FIG. 37). In some embodiments, composite semiconductor layer 3702 comprises crystalline silicon. In some embodiments, a remaining portion of each of the channel structures 2514 penetrates into composite semiconductor layer 3702.

The structure as described in FIG. 37 can be further processed in a similar way as the processes described with reference to FIGS. 12-17; the details of such subsequent steps are not repeated here for ease of description.

The manufacturing process as described herein can include a multi- (e.g., two-) stage etching process on the channel structures, which reduces a risk of collapsing the channel structures due to their height. As a result, the complexity and cost of the fabrication process can be reduced, the product yield can be increased, and the performance of the product can be improved in some cases.

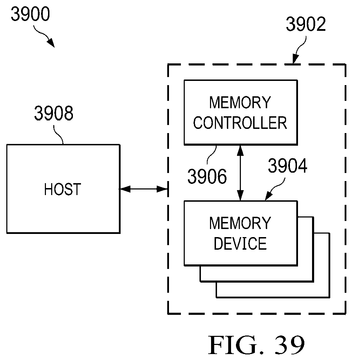

FIG. 39 illustrates a block diagram of an example of system 3900 having a memory device 3904, according to some embodiments of the present disclosure. System 3900 can be, for example, a mobile phone, a desktop computer, a laptop computer, a tablet, a vehicle computer, a gaming console, a printer, a positioning device, a wearable electronic device, a smart sensor, a virtual reality (VR) device, an argument reality (AR) device, or any other suitable electronic devices having storage therein. As shown in FIG. 39, system 3900 can include a host 3908 and a memory system 3902 having one or more memory devices 3904 and a memory controller 3906. Host 3908 can be, for example, a processor of an electronic device, such as a central processing unit (CPU), or a system-on-chip (SoC), such as an application processor (AP). Host 3908 can be configured to send or receive data to or from memory devices 3904.

Memory device 3904 can be any memory device disclosed in the present disclosure, such as 3D memory devices 110, 120, 200, 400. In the present disclosure, memory device 3904 can include channel structures penetrating into a semiconductor layer, where the channel structures can be processed such that an upper end of each channel structure can be aligned horizontally, and a top surface of the semiconductor layer formed over the channel structure is planarized. Therefore, in some implementations, it not only makes the dielectric layer formed over the semiconductor layer thinner, but can also reduce the aspect ratio of the lead-out contacts that are subsequently formed, penetrating the semiconductor layer, which can expand the range of materials for the lead-out contact, thereby eliminating an additional step of forming connection for the lead-out contact. Such features can also lift the restriction on the formation position of the lead-out contacts due to the different depths of gate slit lines, and reduce the difficulty of a subsequent chemical mechanical polishing (CMP) process. As a result, the complexity and cost of the fabrication process can be reduced, and the product yield can be increased in some cases. Furthermore, the 3D memory device 3904 can include a sealing structure disposed at an upper end of each channel structure. The sealing structure can be formed in a channel structure to seal a top portion of the channel structure to prevent other material used in subsequent processes from entering into the channel structure, which may adversely affect an electrical property of the channel structure. As a result, the performance of the device can be improved in some cases.

Memory controller 3906 is coupled to memory device 3904 and host 3908 and is configured to control memory device 3904, according to some embodiments. Memory controller 3906 can manage the data stored in memory device 3904 and communicate with host 3908. In some embodiments, memory controller 3906 is designed for operating in a low duty-cycle environment like secure digital (SD) cards, compact flash (CF) cards, universal serial bus (USB) flash drives, or other media for use in electronic devices, such as personal computers, digital cameras, mobile phones, etc. In some embodiments, memory controller 3906 is designed for operating in a high duty-cycle environment SSDs or embedded multi-media-cards (eMMCs) used as data storage for mobile devices, such as smartphones, tablets, laptop computers, etc., and enterprise storage arrays. Memory controller 3906 can be configured to control operations of memory device 3904, such as read, erase, and program operations.

Memory controller 3906 can also be configured to manage various functions with respect to the data stored or to be stored in memory device 3904 including, but not limited to badblock management, garbage collection, logical-to-physical address conversion, wear leveling, etc. In some implementations, memory controller 106 is further configured to process error correction codes (ECCs) with respect to the data read from or written to memory device 3904. Any other suitable functions may be performed by memory controller 3906 as well, for example, formatting memory device 3904. Memory controller 3906 can communicate with an external device (e.g., host 3908) according to a particular communication protocol. For example, memory controller 3906 may communicate with the external device through at least one of various interface protocols, such as a USB protocol, an MMC protocol, a peripheral component interconnection (PCI) protocol, a PCI-express (PCI-E) protocol, an advanced technology attachment (ATA) protocol, a serial-ATA protocol, a parallel-ATA protocol, a small computer small interface (SCSI) protocol, an enhanced small disk interface (ESDI) protocol, an integrated drive electronics (IDE) protocol, a Firewire protocol, etc.

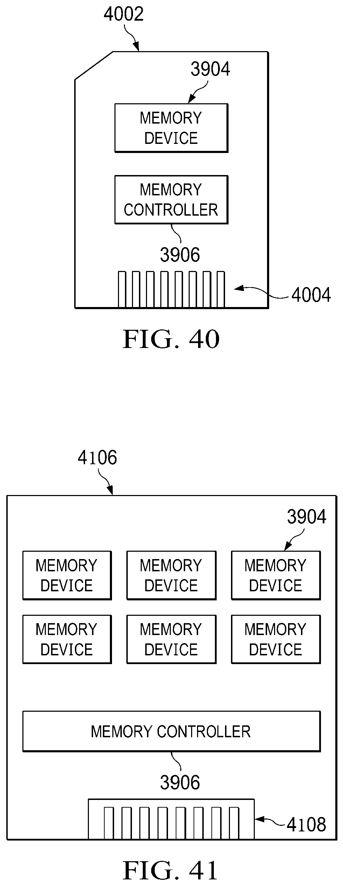

Memory controller 3906 and one or more memory devices 3904 can be integrated into various types of storage devices, for example, and can be included in the same package, such as a universal flash storage (UFS) package or an eMMC package. That is, memory system 3902 can be implemented and packaged into different types of end electronic products. In one example as shown in FIG. 40, memory controller 3906 and a single memory device 3904 may be integrated into a memory card 4002. Memory card 4002 can include a PC card (PCMCIA, personal computer memory card international association), a CF card, a smart media (SM) card, a memory stick, a multimedia card (MMC, RS-MMC, MMCmicro), an SD card (SD, miniSD, microSD, SDHC), a UFS, etc. Memory card 4002 can further include a memory card connector 4004 configured to couple memory card 4002 to a host (e.g., host 3908 in FIG. 39). In another example as shown in FIG. 41, memory controller 3906 and multiple memory devices 3904 may be integrated into an SSD 4106. SSD 4106 can further include an SSD connector 4108 configured to couple SSD 4106 to a host (e.g., host 3908 in FIG. 1). In some implementations, the storage capacity and/or the operation speed of SSD 4106 is greater than those of memory card 4002.

The foregoing description of the specific embodiments will so reveal the general nature of the present disclosure that others can, by applying knowledge within the skill of the art, readily modify and/or adapt for various applications such specific embodiments, without undue experimentation, and/or without departing from the general concept of the present disclosure.

It is to be understood that the phraseology or terminology herein is for the purpose of description and not of limitation, such that the terminology or phraseology of the present specification is to be interpreted by the skilled artisan in light of the teachings and guidance.

Embodiments of the present disclosure have been described above with the aid of functional building blocks illustrating the implementation of specified functions and relationships thereof. The boundaries of these functional building blocks have been arbitrarily defined herein for the convenience of the description. Alternate boundaries can be defined so long as the specified functions and relationships thereof are appropriately performed.

The Summary and Abstract sections may set forth one or more but not all examples of embodiments of the present disclosure as contemplated by the inventor(s), and thus, are not intended to limit the present disclosure and the appended claims in any way.

The breadth and scope of the present disclosure should not be limited by any of the above-described example embodiments. Accordingly, other implementations are also possible, the scope of protection sought being defined solely by the appended claims.

## Claims

1. A method for forming a three-dimensional ,3D, memory device (100, 120, 200, 400, 3904), the method comprising:
providing a semiconductor structure (500), wherein the semiconductor structure (500) comprises a multi-layer stacked structure (204, 504, 1804, 2504), a first semiconductor layer over the multi-layer stacked structure (204, 504, 1804, 2504), a dielectric layer (208, 224, 512, 518, 1402, 1808, 1812, 2102, 2508, 2512, 3202) over the first semiconductor layer, and a substrate over the dielectric layer (208, 224, 512, 518, 1402, 1808, 1812, 2102, 2508, 2512, 3202), wherein the multi-layer stacked structure (204, 504, 1804, 2504) comprises a plurality of alternately stacked conductive layers (206, 506, 1806, 2506) and dielectric layers (208, 224, 512, 518, 1402, 1808, 1812, 2102, 2508, 2512, 3202), wherein the semiconductor structure (500) further comprises a plurality of channel structures (212, 412, 514, 1814, 2514) comprising respective semiconductor channel layers (310), the plurality of channel structures penetrating into the multi-layer stacked structure (204, 504, 1804, 2504), the first semiconductor layer, the dielectric layer (208, 224, 512, 518, 1402, 1808, 1812, 2102, 2508, 2512, 3202), and the substrate;
removing the substrate to expose the dielectric layer (208, 224, 512, 518, 1402, 1808, 1812, 2102, 2508, 2512, 3202);
removing the dielectric layer (208, 224, 512, 518, 1402, 1808, 1812, 2102, 2508, 2512, 3202) and a portion of each of the channel structures (212, 412, 514, 1814, 2514), including removing the respective semiconductor channel layer of the portion that extends beyond the first semiconductor layer of each channel structure (212, 412, 514, 1814, 2514);
depositing a second semiconductor layer (1002, 1102) over the first semiconductor layer, wherein the channel structures (212, 412, 514, 1814, 2514) are electrically coupled to the second semiconductor layer (1002, 1102); and
processing each of the channel structures (212, 412, 514, 1814, 2514) to form a narrow portion in each particular one of the channel structures (212, 412, 514, 1814, 2514), wherein the narrow portion of each particular one of the channel structures (212, 412, 514, 1814, 2514) has a smaller critical dimension than other portions of the particular one of the channel structures (212, 412, 514, 1814, 2514).

2. The method of claim 1, further comprising;
forming a respective semiconductor plug within the narrow portion of each particular one of the channel structures (212, 412, 514, 1814, 2514).

3. The method of any one of claims 1-2, wherein each of the channel structures (212, 412, 514, 1814, 2514) comprises a dielectric filler layer (312), the semiconductor channel layer (310), and a channel film (302), and wherein the channel film (302) comprises a tunneling layer (308), a storage layer (306), and a blocking layer (304, 2702).

4. The method of claim 3, wherein removing the dielectric layer (208, 224, 512, 518, 1402, 1808, 1812, 2102, 2508, 2512, 3202) and the portion of each of the channel structures (212, 412, 514, 1814, 2514) comprises:
etching the channel structures (212, 412, 514, 1814, 2514) and the dielectric layer (208, 224, 512, 518, 1402, 1808, 1812, 2102, 2508, 2512, 3202) to remove a portion of the dielectric layer (208, 224, 512, 518, 1402, 1808, 1812, 2102, 2508, 2512, 3202) and a portion of the channel film (302) of each channel structure (212, 412, 514, 1814, 2514); and
removing a portion of the semiconductor channel layer (310) of each channel structure (212, 412, 514, 1814, 2514) that extends beyond a remaining portion of the dielectric layer (208, 224, 512, 518, 1402, 1808, 1812, 2102, 2508, 2512, 3202).

5. The method of claim 4, wherein removing the dielectric layer (208, 224, 512, 518, 1402, 1808, 1812, 2102, 2508, 2512, 3202) and the portion of each of the channel structures (212, 412, 514, 1814, 2514) further comprises:
etching the dielectric filler layer (312) of each channel structure (212, 412, 514, 1814, 2514) and the remaining portion of the dielectric layer (208, 224, 512, 518, 1402, 1808, 1812, 2102, 2508, 2512, 3202), such that a remaining portion of the semiconductor channel layer (310) of each channel structure (212, 412, 514, 1814, 2514) extends beyond the first semiconductor layer.

6. The method of claim 4, wherein removing the dielectric layer (208, 224, 512, 518, 1402, 1808, 1812, 2102, 2508, 2512, 3202) and the portion of each of the channel structures (212, 412, 514, 1814, 2514) further comprises:
etching the dielectric filler layer (312) of each channel structure (212, 412, 514, 1814, 2514) and the remaining portion of the dielectric layer (208, 224, 512, 518, 1402, 1808, 1812, 2102, 2508, 2512, 3202), such that a top surface of a remaining portion of the dielectric filler layer (312) of each channel structure (212, 412, 514, 1814, 2514) is below a top surface of the first semiconductor layer.

7. The method of claim 3, wherein removing the dielectric layer (208, 224, 512, 518, 1402, 1808, 1812, 2102, 2508, 2512, 3202) and the portion of each of the channel structures (212, 412, 514, 1814, 2514) comprises:
depositing a blocking layer (304, 2702) over the dielectric layer (208, 224, 512, 518, 1402, 1808, 1812, 2102, 2508, 2512, 3202), wherein a portion of one or more of the channel structures (212, 412, 514, 1814, 2514) extends beyond the blocking layer (304, 2702); and
removing a portion of the one or more of the channel structures (212, 412, 514, 1814, 2514) that extends beyond the blocking layer (304, 2702).

8. The method of claim 7, wherein removing the dielectric layer (208, 224, 512, 518, 1402, 1808, 1812, 2102, 2508, 2512, 3202) and the portion of each of the channel structures (212, 412, 514, 1814, 2514) further comprises:
removing the blocking layer (304, 2702) to expose the dielectric layer (208, 224, 512, 518, 1402, 1808, 1812, 2102, 2508, 2512, 3202);
removing the dielectric layer (208, 224, 512, 518, 1402, 1808, 1812, 2102, 2508, 2512, 3202) to expose the first semiconductor layer; and
etching a remaining portion of each of the channel structures (212, 412, 514, 1814, 2514) such that the remaining portion of the semiconductor channel layer (310) of each channel structure (212, 412, 514, 1814, 2514) extends beyond the first semiconductor layer.

9. The method of claim 18, wherein depositing the second semiconductor layer (1002, 1102) over the first semiconductor layer comprises:
depositing the second semiconductor layer (1002, 1102) using a chemical vapor deposition (CVD) method.

10. The method of claim 1-9, wherein before depositing the second semiconductor layer (1002, 1102) over the first semiconductor layer, the method further comprises:
depositing a dielectric layer (208, 224, 512, 518, 1402, 1808, 1812, 2102, 2508, 2512, 3202) over the first semiconductor layer such that a dielectric material of the dielectric layer (208, 224, 512, 518, 1402, 1808, 1812, 2102, 2508, 2512, 3202) partially fills each of the channel structures (212, 412, 514, 1814, 2514); and
etching the dielectric layer (208, 224, 512, 518, 1402, 1808, 1812, 2102, 2508, 2512, 3202) and the dielectric material partially filling each of the channel structures (212, 412, 514, 1814, 2514) to form a dielectric sealing structure in each of the channel structures (212, 412, 514, 1814, 2514).

11. The method of claim 1-10, further comprising:
performing laser annealing of the first semiconductor layer and the second semiconductor layer (1002, 1102) to generate a composite semiconductor layer, wherein a remaining portion of each of the channel structures (212, 412, 514, 1814, 2514) penetrates into the composite semiconductor layer.

12. A three-dimensional ,3D, memory device (100, 120, 200, 400, 3904), comprising:
a multi-layer stacked structure (204, 504, 1804, 2504), wherein the multi-layer stacked structure (204, 504, 1804, 2504) comprises a plurality of alternately stacked conductive layers (206, 506, 1806, 2506) and dielectric layers (208, 224, 512, 518, 1402, 1808, 1812, 2102, 2508, 2512, 3202);
a semiconductor layer over the multi-layer stacked structure (204, 504, 1804, 2504); and
a plurality of channel structures (212, 412, 514, 1814, 2514) penetrating into the multi-layer stacked structure (204, 504, 1804, 2504) and the semiconductor layer, each channel structure comprising a respective semiconductor channel layer (310), wherein a first end of each channel structure (212, 412, 514, 1814, 2514) is located within the semiconductor layer, and wherein the first ends of the channel structures (212, 412, 514, 1814, 2514) are aligned with one another, wherein each particular one of the channel structures (212, 412, 514, 1814, 2514) comprises a narrow portion (426), wherein the narrow portion of each particular one of the channel structures comprises a narrow portion of the respective semiconductor channel layer and is disposed at the first end of the particular one of the channel structures (212, 412, 514, 1814, 2514), and is surrounded laterally by the semiconductor layer, wherein the narrow portion of each particular one of the channel structures has a smaller critical dimension than other portions of the particular one of the channel structures.

13. The 3D memory device (100, 120, 200, 400, 3904) of claim 12, wherein the 3D memory device (100, 120, 200, 400, 3904) further comprises a plurality of first semiconductor plugs disposed at a second end of each particular one of the channel structures (212, 412, 514, 1814, 2514).

14. The 3D memory device (100, 120, 200, 400, 3904) of any one of claims 12-13, wherein each of the channel structures (212, 412, 514, 1814, 2514) comprises a dielectric filler layer (312), the semiconductor channel layer (310), and a channel film (302), and the channel film (302) comprises a tunneling layer (308), a storage layer (306), and a blocking layer (304, 2702), wherein a top surface of the dielectric filler layer (1002, 1102) of each channel structure (212, 412, 514, 1814, 2514) is below a top surface of the semiconductor channel layer (310) and the channel film (302) of each channel structure (212, 412, 514, 1814, 2514).

15. The 3D memory device (100, 120, 200, 400, 3904) of claim 12-14, wherein a dielectric sealing structure is disposed within each of the channel structures (212, 412, 514, 1814, 2514) at the first end of each of the channel structures (212, 412, 514, 1814, 2514), and wherein a respective second semiconductor plug is disposed over the dielectric sealing structure in each of the channel structures (212, 412, 514, 1814, 2514).

## Patentansprüche

1. Verfahren zur Herstellung einer dreidimensionalen (3D) Speichervorrichtung (100, 120, 200, 400, 3904), wobei das Verfahren folgende Schritte aufweist:
Bereitstellen einer Halbleiterstruktur (500), wobei die Halbleiterstruktur (500) eine mehrschichtige gestapelte Struktur (204, 504, 1804, 2504), eine erste Halbleiterschicht über der mehrschichtigen gestapelten Struktur (204, 504, 1804, 2504), eine dielektrische Schicht (208, 224, 512, 518, 1402, 1808, 1812, 2102, 2508, 2512, 3202) über der ersten Halbleiterschicht und ein Substrat über der dielektrischen Schicht (208, 224, 512, 518, 1402, 1808, 1812, 2102, 2508, 2512, 3202) aufweist,
wobei die mehrschichtige gestapelte Struktur (204, 504, 1804, 2504) eine Vielzahl von abwechselnd gestapelten leitfähigen Schichten (206, 506, 1806, 2506) und dielektrischen Schichten (208, 224, 512, 518, 1402, 1808, 1812, 2102, 2508, 2512, 3202) aufweist,
wobei die Halbleiterstruktur (500) ferner eine Vielzahl von Kanalstrukturen (212, 412, 514, 1814, 2514) aufweist, die jeweils eine Halbleiter-Kanalschicht (310) aufweisen, wobei die Vielzahl von Kanalstrukturen in die mehrschichtige gestapelte Struktur (204, 504, 1804, 2504), die erste Halbleiterschicht, die dielektrische Schicht (208, 224, 512, 518, 1402, 1808, 1812, 2102, 2508, 2512, 3202) und das Substrat hineinreichen;
Entfernen des Substrats, um die dielektrische Schicht (208, 224, 512, 518, 1402, 1808, 1812, 2102, 2508, 2512, 3202) freizulegen;
Entfernen der dielektrischen Schicht (208, 224, 512, 518, 1402, 1808, 1812, 2102, 2508, 2512, 3202) und eines Abschnitts von jeder der Kanalstrukturen (212, 412, 514, 1814, 2514), einschließlich eines Entfernens der jeweiligen Halbleiter-Kanalschicht des Abschnitts, der über die erste Halbleiterschicht jeder Kanalstruktur (212, 412, 514, 1814, 2514) hinausragt;
Aufbringen einer zweiten Halbleiterschicht (1002, 1102) über der ersten Halbleiterschicht, wobei die Kanalstrukturen (212, 412, 514, 1814, 2514) elektrisch mit der zweiten Halbleiterschicht (1002, 1102) gekoppelt sind; und
Bearbeiten jeder der Kanalstrukturen (212, 412, 514, 1814, 2514), um in jeder einzelnen der Kanalstrukturen (212, 412, 514, 1814, 2514) einen schmalen Abschnitt zu bilden, wobei der schmale Abschnitt jeder einzelnen der Kanalstrukturen (212, 412, 514, 1814, 2514) eine kleinere kritische Abmessung aufweist als andere Abschnitte der jeweiligen der Kanalstrukturen (212, 412, 514, 1814, 2514).

2. Verfahren nach Anspruch 1, das ferner folgenden Schritt aufweist:
Bilden eines jeweiligen Halbleiter-Stopfens innerhalb des schmalen Abschnitts jeder einzelnen der Kanalstrukturen (212, 412, 514, 1814, 2514).

3. Verfahren nach einem der Ansprüche 1 - 2, wobei jede der Kanalstrukturen (212, 412, 514, 1814, 2514) eine dielektrische Füllschicht (312), die Halbleiter-Kanalschicht (310) und einen Kanal-Film (302) aufweist, und wobei der Kanal-Film (302) eine Tunnelschicht (308), eine Speicherschicht (306) und eine Sperrschicht (304, 2702) aufweist.

4. Verfahren nach Anspruch 3, wobei das Entfernen der dielektrischen Schicht (208, 224, 512, 518, 1402, 1808, 1812, 2102, 2508, 2512, 3202) und des Abschnitts jeder der Kanalstrukturen (212, 412, 514, 1814, 2514) folgende Schritte aufweist:
Ätzen der Kanalstrukturen (212, 412, 514, 1814, 2514) und der dielektrischen Schicht (208, 224, 512, 518, 1402, 1808, 1812, 2102, 2508, 2512, 3202), um einen Abschnitt der dielektrischen Schicht (208, 224, 512, 518, 1402, 1808, 1812, 2102, 2508, 2512, 3202) und einen Abschnitt des Kanal-Films (302) jeder Kanalstruktur (212, 412, 514, 1814, 2514) zu entfernen; und
Entfernen eines Abschnitts der Halbleiter-Kanalschicht (310) jeder Kanalstruktur (212, 412, 514, 1814, 2514), der sich über einen verbleibenden Abschnitt der dielektrischen Schicht (208, 224, 512, 518, 1402, 1808, 1812, 2102, 2508, 2512, 3202) hinaus erstreckt.

5. Verfahren nach Anspruch 4, wobei das Entfernen der dielektrischen Schicht (208, 224, 512, 518, 1402, 1808, 1812, 2102, 2508, 2512, 3202) und des Abschnitts jeder der Kanalstrukturen (212, 412, 514, 1814, 2514) ferner folgenden Schritt aufweist:
Ätzen der dielektrischen Füllschicht (312) jeder Kanalstruktur (212, 412, 514, 1814, 2514) und des verbleibenden Abschnitts der dielektrischen Schicht (208, 224, 512, 518, 1402, 1808, 1812, 2102, 2508, 2512, 3202), so dass sich ein verbleibender Abschnitt der Halbleiter-Kanalschicht (310) jeder Kanalstruktur (212, 412, 514, 1814, 2514) über die erste Halbleiterschicht hinaus erstreckt.

6. Verfahren nach Anspruch 4, wobei das Entfernen der dielektrischen Schicht (208, 224, 512, 518, 1402, 1808, 1812, 2102, 2508, 2512, 3202) und des Abschnitts jeder der Kanalstrukturen (212, 412, 514, 1814, 2514) ferner folgenden Schritt aufweist:
Ätzen der dielektrischen Füllschicht (312) jeder Kanalstruktur (212, 412, 514, 1814, 2514) und des verbleibenden Abschnitts der dielektrischen Schicht (208, 224, 512, 518, 1402, 1808, 1812, 2102, 2508, 2512, 3202) derart, dass eine Oberseite eines verbleibenden Abschnitts der dielektrischen Füllschicht (312) jeder Kanalstruktur (212, 412, 514, 1814, 2514) unterhalb einer Oberseite der ersten Halbleiterschicht liegt.

7. Verfahren nach Anspruch 3, wobei das Entfernen der dielektrischen Schicht (208, 224, 512, 518, 1402, 1808, 1812, 2102, 2508, 2512, 3202) und des Abschnitts jeder der Kanalstrukturen (212, 412, 514, 1814, 2514) folgende Schritte aufweist:
Aufbringen einer Sperrschicht (304, 2702) über der dielektrischen Schicht (208, 224, 512, 518, 1402, 1808, 1812, 2102, 2508, 2512, 3202), wobei sich ein Abschnitt einer oder mehrerer der Kanalstrukturen (212, 412, 514, 1814, 2514) über die Sperrschicht (304, 2702) hinaus erstreckt; und
Entfernen eines Abschnitts der einen oder mehreren Kanalstrukturen (212, 412, 514, 1814, 2514), der sich über die Sperrschicht (304, 2702) hinaus erstreckt.

8. Verfahren nach Anspruch 7, wobei das Entfernen der dielektrischen Schicht (208, 224, 512, 518, 1402, 1808, 1812, 2102, 2508, 2512, 3202) und des Abschnitts jeder der Kanalstrukturen (212, 412, 514, 1814, 2514) ferner aufweist:
Entfernen der Sperrschicht (304, 2702), um die dielektrische Schicht (208, 224, 512, 518, 1402, 1808, 1812, 2102, 2508, 2512, 3202) freizulegen;
Entfernen der dielektrischen Schicht (208, 224, 512, 518, 1402, 1808, 1812, 2102, 2508, 2512, 3202), um die erste Halbleiterschicht freizulegen; und Ätzen eines verbleibenden Abschnitts jeder der Kanalstrukturen (212, 412, 514, 1814, 2514) derart, dass sich der verbleibende Abschnitt der Halbleiter-Kanalschicht (310) jeder Kanalstruktur (212, 412, 514, 1814, 2514) über die erste Halbleiterschicht hinaus erstreckt.

9. Verfahren nach Anspruch 1-8, wobei das Aufbringen der zweiten Halbleiterschicht (1002, 1102) über der ersten Halbleiterschicht folgenden Schritt aufweist:
Aufbringen der zweiten Halbleiterschicht (1002, 1102) unter Verwendung eines Verfahrens der chemischen Gasphasenabscheidung (CVD).

10. Verfahren nach Anspruch 1 - 9, wobei das Verfahren vor dem Aufbringen der zweiten Halbleiterschicht (1002, 1102) auf die erste Halbleiterschicht ferner folgende Schritte aufweist:
Aufbringen einer dielektrischen Schicht (208, 224, 512, 518, 1402, 1808, 1812, 2102, 2508, 2512, 3202) über der ersten Halbleiterschicht, so dass ein dielektrisches Material der dielektrischen Schicht (208, 224, 512, 518, 1402, 1808, 1812, 2102, 2508, 2512, 3202) jede der Kanalstrukturen (212, 412, 514, 1814, 2514) teilweise ausfüllt; und
Ätzen der dielektrischen Schicht (208, 224, 512, 518, 1402, 1808, 1812, 2102, 2508, 2512, 3202) und des dielektrischen Materials, das jede der Kanalstrukturen (212, 412, 514, 1814, 2514) teilweise ausfüllt, um in jeder der Kanalstrukturen (212, 412, 514, 1814, 2514) eine dielektrische Dichtungsstruktur zu bilden.

11. Verfahren nach Anspruch 1 - 10, das ferner folgenden Schritt aufweist:
Durchführen einer Laser-Temperaturbehandlung der ersten Halbleiterschicht und der zweiten Halbleiterschicht (1002, 1102), um eine Verbund-Halbleiterschicht zu erzeugen, wobei ein verbleibender Abschnitt jeder der Kanalstrukturen (212, 412, 514, 1814, 2514) in die Verbund-Halbleiterschicht hineinreicht.

12. Eine dreidimensionale (3D) Speichervorrichtung (100, 120, 200, 400, 3904), die folgendes aufweist:
eine mehrschichtige gestapelte Struktur (204, 504, 1804, 2504), wobei die mehrschichtige gestapelte Struktur (204, 504, 1804, 2504) eine Vielzahl von abwechselnd gestapelten leitfähigen Schichten (206, 506, 1806, 2506) und dielektrischen Schichten (208, 224, 512, 518, 1402, 1808, 1812, 2102, 2508, 2512, 3202) aufweist;
eine Halbleiterschicht über der mehrschichtigen gestapelten Struktur (204, 504, 1804, 2504); und
eine Vielzahl von Kanalstrukturen (212, 412, 514, 1814, 2514), die sich in die mehrschichtige gestapelte Struktur (204, 504, 1804, 2504) und die Halbleiterschicht hinein erstrecken, wobei sich ein erstes Ende jeder Kanalstruktur (212, 412, 514, 1814, 2514) innerhalb der Halbleiterschicht befindet und wobei die ersten Enden der Kanalstrukturen (212, 412, 514, 1814, 2514) zueinander fluchtend ausgerichtet sind, wobei jede einzelne der Kanalstrukturen (212, 412, 514, 1814, 2514) einen schmalen Abschnitt (426) aufweist, wobei der schmale Abschnitt jeder einzelnen der Kanalstrukturen einen schmalen Abschnitt der jeweiligen Halbleiter-Kanalschicht aufweist und am ersten Ende der jeweiligen Kanalstruktur (212, 412, 514, 1814, 2514) angeordnet ist und seitlich von der Halbleiterschicht umgeben ist, wobei der schmale Abschnitt jeder einzelnen der Kanalstrukturen eine kleinere kritische Abmessung aufweist als andere Abschnitte der jeweiligen Kanalstruktur.

13. 3D-Speichervorrichtung (100, 120, 200, 400, 3904) nach Anspruch 12, wobei die 3D-Speichervorrichtung (100, 120, 200, 400, 3904) ferner eine Vielzahl von ersten Halbleiter-Stopfen aufweist, die an einem zweiten Ende von jeder einzelnen der Kanalstrukturen (212, 412, 514, 1814, 2514) angeordnet sind.

14. 3D-Speichervorrichtung (100, 120, 200, 400, 3904) nach einem der Ansprüche 12 - 13, wobei jede der Kanalstrukturen (212, 412, 514, 1814, 2514) eine dielektrische Füllschicht (312), die Halbleiter-Kanalschicht (310) und einen Kanal-Film (302) aufweist, und wobei der Kanal-Film (302) eine Tunnelschicht (308), eine Speicherschicht (306) und eine Sperrschicht (304, 2702) aufweist, wobei eine Oberseite der dielektrischen Füllschicht (1002, 1102) jeder Kanalstruktur (212, 412, 514, 1814, 2514) unterhalb einer Oberseite der Halbleiter-Kanalschicht (310) und des Kanal-Films (302) jeder Kanalstruktur (212, 412, 514, 1814, 2514) liegt.

15. 3D-Speichervorrichtung (100, 120, 200, 400, 3904) nach Anspruch 12 - 14, wobei eine dielektrische Dichtungsstruktur innerhalb jeder der Kanalstrukturen (212, 412, 514, 1814, 2514) am ersten Ende jeder der Kanalstrukturen (212, 412, 514, 1814, 2514) angeordnet ist und wobei ein jeweiliger zweiter Halbleiter-Stopfen über der dielektrischen Dichtungsstruktur in jeder der Kanalstrukturen (212, 412, 514, 1814, 2514) angeordnet ist.

## Revendications

1. Procédé pour former un dispositif de mémoire tridimensionnelle, 3D, (100, 120, 200, 400, 3904), le procédé comprenant les étapes consistant à :
fournir une structure semi-conductrice (500), la structure semi-conductrice (500) comprenant une structure empilée multicouche (204, 504, 1804, 2504), une première couche semi-conductrice au-dessus de la structure empilée multicouche (204, 504, 1804, 2504), une couche diélectrique (208, 224, 512, 518, 1402, 1808, 1812, 2102, 2508, 2512, 3202) au-dessus de la première couche semi-conductrice, et un substrat au-dessus de la couche diélectrique (208, 224, 512, 518, 1402, 1808, 1812, 2102, 2508, 2512, 3202), la structure empilée multicouche (204, 504, 1804, 2504) comprenant une pluralité de couches conductrices (206, 506, 1806, 2506) et couches diélectriques (208, 224, 512, 518, 1402, 1808, 1812, 2102, 2508, 2512, 3202) empilées en alternance, la structure semi-conductrice (500) comprenant en outre une pluralité de structures formant canaux (212, 412, 514, 1814, 2514) comprenant une couche à canal semi-conductrice (310), la pluralité de structures formant canaux pénétrant jusque dans la structure empilée multicouche (204, 504, 1804, 2504), la première couche semi-conductrice, la couche diélectrique (208, 224, 512, 518, 1402, 1808, 1812, 2102, 2508, 2512, 3202), et le substrat ;
enlever le substrat pour exposer la couche diélectrique (208, 224, 512, 518, 1402, 1808, 1812, 2102, 2508, 2512, 3202) ;
enlever la couche diélectrique (208, 224, 512, 518, 1402, 1808, 1812, 2102, 2508, 2512, 3202) et une portion de chacune des structures formant canaux (212, 412, 514, 1814, 2514), incluant d'enlever la couche à canal semi-conductrice respective de la portion qui s'étend au-delà de la première couche semi-conductrice de chaque structure formant canal (212, 412, 514, 1814, 2514) ;
déposer une deuxième couche semi-conductrice (1002, 1102) au-dessus de la première couche semi-conductrice, les structures formant canaux (212, 412, 514, 1814, 2514) étant couplées électriquement à la deuxième couche semi-conductrice (1002, 1102) ; et
traiter chacune des structures formant canaux (212, 412, 514, 1814, 2514) pour former une portion étroite dans chaque structure particulière des structures formant canaux (212, 412, 514, 1814, 2514), la portion étroite de chaque structure particulière des structures formant canaux (212, 412, 514, 1814, 2514) ayant une dimension critique plus petite que d'autres portions de la structure particulière des structures formant canaux (212, 412, 514, 1814, 2514).

2. Procédé selon la revendication 1, comprenant en outre l'étape consistant à :
former un bouchon semi-conducteur respectif à l'intérieur de la portion étroite de chaque structure particulière des structures formant canaux (212, 412, 514, 1814, 2514).

3. Procédé selon l'une quelconque des revendications 1 à 2, dans lequel chacune des structures formant canaux (212, 412, 514, 1814, 2514) comprend une couche de remplissage diélectrique (312), la couche à canal semi-conductrice (310), et un film de canal (302), et dans lequel le film de canal (302) comprend une couche de tunnellisation (308), une couche de stockage (306), et une couche de blocage (304, 2702).

4. Procédé selon la revendication 3, dans lequel l'étape consistant à enlever la couche diélectrique (208, 224, 512, 518, 1402, 1808, 1812, 2102, 2508, 2512, 3202) et la portion de chacune des structures formant canaux (212, 412, 514, 1814, 2514) comprend de :
graver les structures formant canaux (212, 412, 514, 1814, 2514) et la couche diélectrique (208, 224, 512, 518, 1402, 1808, 1812, 2102, 2508, 2512, 3202) pour enlever une portion de la couche diélectrique (208, 224, 512, 518, 1402, 1808, 1812, 2102, 2508, 2512, 3202) et une portion du film de canal (302) de chaque structure formant canal (212, 412, 514, 1814, 2514) ; et
enlever une portion de la couche à canal semi-conductrice (310) chaque structure formant canal (212, 412, 514, 1814, 2514) qui s'étend au-delà d'une portion restante de la couche diélectrique (208, 224, 512, 518, 1402, 1808, 1812, 2102, 2508, 2512, 3202).

5. Procédé selon la revendication 4, dans lequel l'étape consistant à enlever la couche diélectrique (208, 224, 512, 518, 1402, 1808, 1812, 2102, 2508, 2512, 3202) et la portion de chacune des structures formant canaux (212, 412, 514, 1814, 2514) comprend en outre de :
graver la couche de remplissage diélectrique (312) de chaque structure formant canal (212, 412, 514, 1814, 2514) et la portion restante de la couche diélectrique (208, 224, 512, 518, 1402, 1808, 1812, 2102, 2508, 2512, 3202), de telle sorte qu'une portion restante de la couche à canal semi-conductrice (310) de chaque structure formant canal (212, 412, 514, 1814, 2514) s'étend au-delà de la première couche semi-conductrice.

6. Procédé selon la revendication 4, dans lequel l'étape consistant à enlever la couche diélectrique (208, 224, 512, 518, 1402, 1808, 1812, 2102, 2508, 2512, 3202) et la portion de chacune des structures formant canaux (212, 412, 514, 1814, 2514) comprend en outre de :
graver la couche de remplissage diélectrique (312) de chaque structure formant canal (212, 412, 514, 1814, 2514) et la portion restante de la couche diélectrique (208, 224, 512, 518, 1402, 1808, 1812, 2102, 2508, 2512, 3202) de telle sorte qu'une surface de sommet d'une portion restante de la couche de remplissage diélectrique (312) de chaque structure formant canal (212, 412, 514, 1814, 2514) est en dessous d'une surface de sommet de la première couche semi-conductrice.

7. Procédé selon la revendication 3, dans lequel l'étape consistant à enlever la couche diélectrique (208, 224, 512, 518, 1402, 1808, 1812, 2102, 2508, 2512, 3202) et la portion de chacune des structures formant canaux (212, 412, 514, 1814, 2514) comprend de :
déposer une couche de blocage (304, 2702) au-dessus de la couche diélectrique (208, 224, 512, 518, 1402, 1808, 1812, 2102, 2508, 2512, 3202), une portion desdites une ou plusieurs des structures formant canaux (212, 412, 514, 1814, 2514) s'étendant au-delà de la couche de blocage (304, 2702) ; et
enlever une portion desdites une ou plusieurs structures formant canaux (212, 412, 514, 1814, 2514) qui s'étend au-delà de la couche de blocage (304, 2702).

8. Procédé selon la revendication 7, dans lequel l'étape consistant à enlever la couche diélectrique (208, 224, 512, 518, 1402, 1808, 1812, 2102, 2508, 2512, 3202) et la portion de chacune des structures formant canaux (212, 412, 514, 1814, 2514) comprend en outre de :
enlever la couche de blocage (304, 2702) pour exposer la couche diélectrique (208, 224, 512, 518, 1402, 1808, 1812, 2102, 2508, 2512, 3202) ;
enlever la couche diélectrique (208, 224, 512, 518, 1402, 1808, 1812, 2102, 2508, 2512, 3202) pour exposer la première couche semi-conductrice ; et
graver une portion restante de chacune des structures formant canaux (212, 412, 514, 1814, 2514) de telle sorte que la portion restante de la couche à canal semi-conductrice (310) de chaque structure formant canal (212, 412, 514, 1814, 2514) s'étend au-delà de la première couche semi-conductrice.

9. Procédé selon la revendication 1-8, dans lequel l'étape consistant à déposer la deuxième couche semi-conductrice (1002, 1102) au-dessus de la première couche semi-conductrice comprend de :
déposer la deuxième couche semi-conductrice layer (1002, 1102) par la méthode de dépôt chimique en phase vapeur (CVD, chemical vapor deposition).

10. Procédé selon les revendications 1 à 9, dans lequel, avant l'étape consistant à déposer la deuxième couche semi-conductrice (1002, 1102) au-dessus de la première couche semi-conductrice, le procédé comprend en outre l'étape consistant à :
déposer une couche diélectrique (208, 224, 512, 518, 1402, 1808, 1812, 2102, 2508, 2512, 3202) au-dessus de la première couche semi-conductrice de telle sorte qu'un matériau diélectrique de la couche diélectrique (208, 224, 512, 518, 1402, 1808, 1812, 2102, 2508, 2512, 3202) remplit partiellement chacune des structures formant canaux (212, 412, 514, 1814, 2514) ; et
graver la couche diélectrique (208, 224, 512, 518, 1402, 1808, 1812, 2102, 2508, 2512, 3202) et le matériau diélectrique remplissant en partie chacune des structures formant canaux (212, 412, 514, 1814, 2514) pour former une structure d'étanchéité diélectrique dans chacune des structures formant canaux (212, 412, 514, 1814, 2514).

11. Procédé selon les revendications 1 à 10, comprenant en outre les étapes consistant à :
effectuer un recuit au laser de la première couche semi-conductrice et de la deuxième couche semi-conductrice (1002, 1102) pour générer une couche semi-conductrice composite, une portion restante de chacune des structures formant canaux (212, 412, 514, 1814, 2514) pénétrant jusque dans la couche semi-conductrice composite.

12. Dispositif de mémoire tridimensionnelle,3D, (100, 120, 200, 400, 3904), comprenant :
une structure empilée multicouche (204, 504, 1804, 2504), la structure empilée multicouche (204, 504, 1804, 2504) comprenant une pluralité de couches conductrices (206, 506, 1806, 2506) et couches diélectriques (208, 224, 512, 518, 1402, 1808, 1812, 2102, 2508, 2512, 3202) empilées en alternance ;
une couche semi-conductrice au-dessus de la structure empilée multicouche (204, 504, 1804, 2504) ; et
une pluralité de structures formant canaux (212, 412, 514, 1814, 2514) pénétrant jusque dans la structure empilée multicouche (204, 504, 1804, 2504) et la couche semi-conductrice, une première extrémité de chaque structure formant canal (212, 412, 514, 1814, 2514) étant située à l'intérieur de la couche semi-conductrice, et les premières extrémités des structures formant canaux (212, 412, 514, 1814, 2514) étant alignées les unes avec les autres, chaque structure particulière des structures formant canaux (212, 412, 514, 1814, 2514) comprenant une portion étroite (426), la portion étroite de chaque structure particulière des structures formant canaux comprenant une portion étroite de la couche à canal semi-conductrice respective et étant disposée au niveau de la première extrémité de ladite une structure particulière des structures formant canaux (212, 412, 514, 1814, 2514), et étant entourée latéralement par la couche semi-conductrice, la portion étroite de chaque structure particulière des structures formant canaux ayant une dimension critique plus petite que d'autres portions de ladite une structure particulière des structures formant canaux.

13. Dispositif de mémoire 3D (100, 120, 200, 400, 3904) selon la revendication 12, dans lequel le dispositif de mémoire 3D (100, 120, 200, 400, 3904) comprend en outre une pluralité de premiers bouchons semi-conducteurs disposés au niveau d'une deuxième extrémité de chaque structure particulière des structures formant canaux (212, 412, 514, 1814, 2514).

14. Dispositif de mémoire 3D (100, 120, 200, 400, 3904) selon l'une quelconque des revendications 12 à 13, dans lequel chacune des structures formant canaux (212, 412, 514, 1814, 2514) comprend une couche de remplissage diélectrique (312), la couche à canal semi-conductrice (310), et un film de canal (302), et le film de canal (302) comprend une couche de tunnellisation (308), une couche de stockage (306), et une couche de blocage (304, 2702), dans lequel une surface de sommet de la couche de remplissage diélectrique (1002, 1102) de chaque structure formant canal (212, 412, 514, 1814, 2514) est en dessous d'une surface de sommet de la couche à canal semi-conductrice (310) et le film de canal (302) de chaque structure à canal (212, 412, 514, 1814, 2514).

15. Dispositif de mémoire 3D (100, 120, 200, 400, 3904) selon les revendications 12 à 14, dans lequel une structure d'étanchéité diélectrique est disposée à l'intérieur de chacune des structures formant canaux (212, 412, 514, 1814, 2514) au niveau de la première extrémité de chacune des structures formant canaux (212, 412, 514, 1814, 2514), et dans lequel un deuxième bouchon semi-conducteur respectif est disposé au-dessus de la structure d'étanchéité diélectrique dans chacune des structures formant canaux (212, 412, 514, 1814, 2514).
